(19) Europäisches Patentamt
European Patent Office
Office européen des brevets

(11) **EP 4 506 981 A1**

(12) **EUROPEAN PATENT APPLICATION**
published in accordance with Art. 153(4) EPC

(43) Date of publication:
**12.02.2025 Bulletin 2025/07**

(21) Application number: **23784821.3**

(22) Date of filing: **07.04.2023**

(51) International Patent Classification (IPC):
**H01L 21/304** (2006.01)

(52) Cooperative Patent Classification (CPC):
**H01L 21/304**

(86) International application number:
**PCT/JP2023/014402**

(87) International publication number:
**WO 2023/195537 (12.10.2023 Gazette 2023/41)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **08.04.2022 JP 2022064479**

(71) Applicant: **EBARA CORPORATION
Ota-ku,
Tokyo 144-8510 (JP)**

(72) Inventor: **ISHII, Yu
Tokyo 144-8510 (JP)**

(74) Representative: **Pritzlaff, Stefanie Lydia
Wagner & Geyer Partnerschaft mbB
Patent- und Rechtsanwälte
Gewürzmühlstraße 5
80538 München (DE)**

(54) **SUBSTRATE CLEANING DEVICE, SUBSTRATE PROCESSING DEVICE, SUBSTRATE CLEANING METHOD, AND PROGRAM**

(57) A substrate cleaning apparatus includes a cleaning module including a transfer mechanism for transferring a substrate in a first direction, and bringing, into contact with the substrate transferred in the first direction, a cleaning member rotating about a rotation axis extending in a second direction that is not perpendicular to the first direction, to perform cleaning, and a control device that changes a cleaning condition including at least one of a direction of the rotation axis, a rotation speed of the cleaning member and a transfer speed of the substrate based on information about at least one of the substrate and the cleaning module.

Fig. 8

EP 4 506 981 A1

**Description**

TECHNICAL FIELD

The present invention relates to a substrate cleaning apparatus, a substrate processing apparatus, a substrate cleaning method, and program.

BACKGROUND ART

Processing a substrate for manufacturing a semiconductor device or the like includes bringing a cleaning member such as a cleaning brush into contact with a surface of the substrate, to clean the substrate.

In PTLs 1 and 2, the substrate is cleaned with a brush inclined to a direction orthogonal to a direction of movement of the substrate. In a substrate cleaning method of PTL 3, both sides of a wafer immersed in a cleaning solution are cleaned while driving and reciprocating the wafer in a horizontal direction with a feed roller.

CITATION LIST

PATENT LITERATURES

PTL 1: Japanese Patent No. 4287551
PTL 2: Japanese Patent Laid-Open No. 2009-128910
PTL 3: Japanese Patent Publication No. HEI 06-091986

SUMMARY OF INVENTION

TECHNICAL PROBLEM

In the substrate cleaning method described above, a substrate may not be sufficiently cleaned, for example, because a direction in which the surface of a brush moves relative to the substrate is constant.

The present invention has been made in view of the above-described circumstances, and one of objects thereof is to provide a substrate made cleaner by cleaning.

SOLUTION TO PROBLEM

According to an embodiment of the present invention, a substrate cleaning apparatus includes a cleaning module including a transfer mechanism for transferring a substrate in a first direction, and bringing, into contact with the substrate transferred in the first direction, a cleaning member rotating about a rotation axis extending in a second direction that is not perpendicular to the first direction, to perform cleaning, and a control device that changes a cleaning condition including at least one of a direction of the rotation axis, a rotation speed of the cleaning member and a transfer speed of the substrate based on information about at least one of the substrate and the cleaning module.

According to another embodiment of the present invention, a substrate cleaning method includes transferring a substrate in a first direction, bringing, into contact with the substrate transferred in the first direction, a cleaning member rotating about a rotation axis extending in a second direction that is not perpendicular to the first direction, to perform cleaning, and changing a cleaning condition including at least one of a direction of the rotation axis, a rotation speed of the cleaning member and a transfer speed of the substrate based on information about at least one of the substrate and the cleaning module.

According to still another embodiment of the present invention, a program causes a processor of a substrate cleaning apparatus comprising a cleaning module to perform change processing of changing a cleaning condition including at least one of a direction of a rotation axis, a rotation speed of a cleaning member and a transfer speed of a substrate based on information about at least one of the substrate and the cleaning module, the cleaning module including a transfer mechanism for transferring the substrate in a first direction, and bringing, into contact with the substrate transferred in the first direction, the cleaning member rotating about the rotation axis extending in a second direction that is not perpendicular to the first direction, to perform cleaning.

BRIEF DESCRIPTION OF DRAWINGS

Fig. 1 is a conceptual diagram showing a substrate processing apparatus of one embodiment.
Fig. 2 is a perspective view showing a transfer mechanism of a load module according to the above embodiment.
Fig. 3 is a plan view showing a rectangular substrate according to the above embodiment.
Fig. 4 is a cross-sectional view schematically showing a transfer module according to the above embodiment.
Fig. 5 is a perspective view schematically showing a polishing module according to the above embodiment.
Fig. 6 is a plan view schematically showing a cleaning module according to the above embodiment.
Fig. 7 is a conceptual diagram showing a scrub cleaning mechanism according to the above embodiment.
Fig. 8 is a conceptual diagram for describing a rotation axis angle.
Fig. 9 is a conceptual diagram for describing movement of a sponge surface on the substrate.
Fig. 10 is a conceptual diagram showing a configuration of a control device according to the above embodiment.
Fig. 11 is a flowchart showing a flow of a substrate processing method according to the above embodiment.
Fig. 12 is a plan view schematically showing an arrangement of a sensor according to Modification 1.
Fig. 13 is a flowchart showing a flow of a substrate processing method according to Modification 1.
Fig. 14 is a flowchart showing a flow of a substrate processing method according to Modification 2.
Fig. 15 is a plan view schematically showing an arrangement of a sensor according to Modification 3.
Fig. 16 is a flowchart showing a flow of a substrate processing method according to Modification 3.
Fig. 17 is a conceptual diagram of a cleaning member according to Modification 4 viewed along an axial direction.
Fig. 18 is a conceptual diagram showing a scrub cleaning mechanism according to Modification 5.

DESCRIPTION OF EMBODIMENTS

Hereinafter, embodiments of the present invention will be described with reference to the drawings. In the drawings described below, the same or corresponding components are denoted with the same reference signs and duplicate descriptions are not repeated.

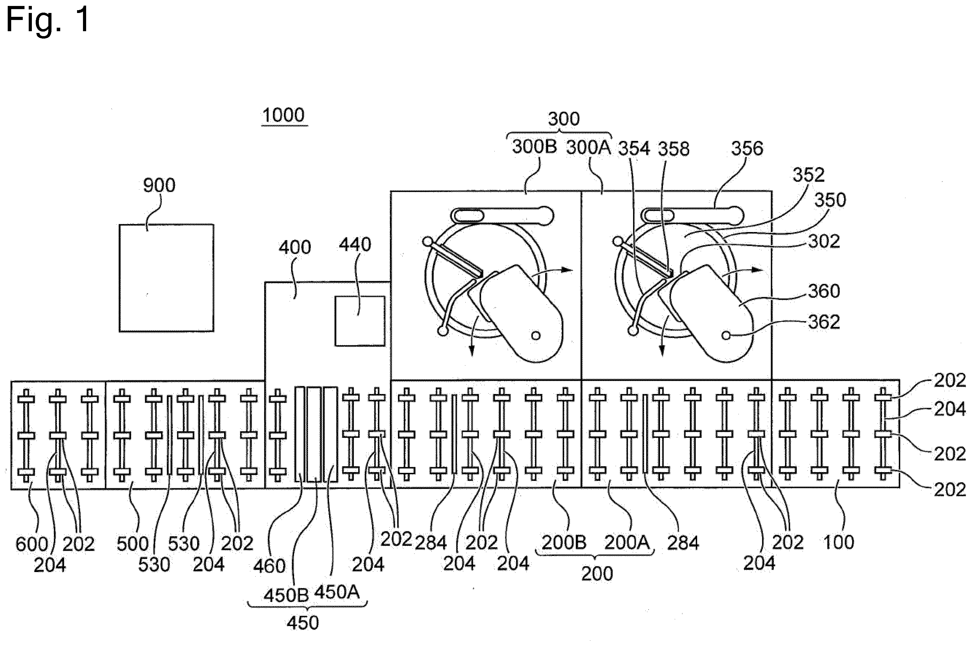

Fig. 1 is a plan view schematically showing an overall configuration of a substrate processing apparatus 1000 according to the present embodiment. The substrate processing apparatus 1000 shown in Fig. 1 includes a load module 100, transfer modules 200A and 200B, polishing modules 300A and 300B, a cleaning module 400, a drying module 500, an unload module 600 and a control device 900. Respective components of the substrate processing apparatus 1000 are controlled by the control device 900. The substrate processing apparatus 1000 of the present embodiment is a substrate polishing apparatus for polishing a substrate. However, processing of the substrate processing apparatus 1000 is not particularly limited to any type when the apparatus includes the cleaning module.

<Load Module>

The load module 100 introduces a substrate WF before being polished or otherwise processed into the substrate processing apparatus 1000. The load module 100 is preferably configured to comply with mechanical equipment interface standards (IPC-SMEMA-9851) of Surface Mount Equipment Manufacturers Association (SMEMA). A configuration of the load module 100 is not particularly limited if it is possible to perform cleaning with the cleaning module 400 described later.

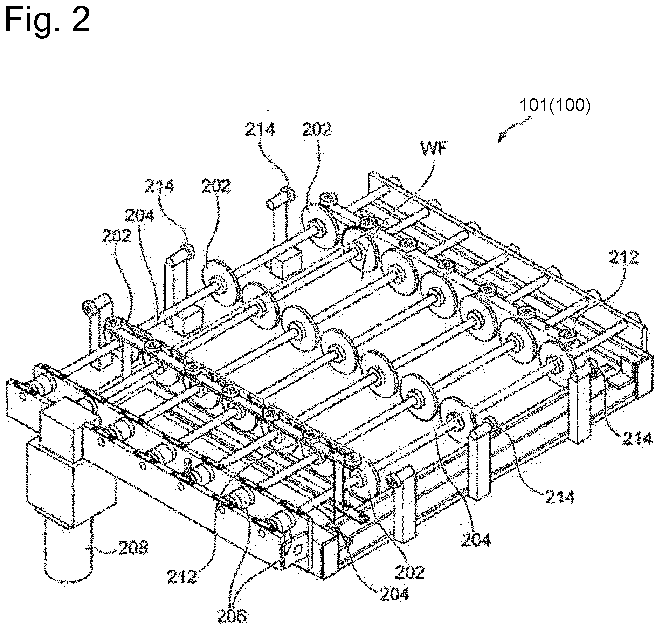

Fig. 2 is a perspective view schematically showing a substrate transfer mechanism 101 in the load module 100. The load module 100 includes an unshown housing in which an inlet opening is formed, through which the substrate WF passes during transfer-in, and the substrate transfer mechanism 101 is disposed inside the housing. The substrate transfer mechanism 101 includes a plurality of transfer rollers 202 and a plurality of roller shafts 204 to which the transfer rollers 202 are mounted. In the illustrated embodiment, three transfer rollers 202 are mounted to each roller shaft 204. The substrate WF (schematically indicated by a double dashed chain line) is disposed on the transfer roller 202, and the substrate WF is transferred by rotating the transfer roller 202. A position to which the transfer roller 202 is mounted on the roller shaft 204 can be freely selected if it is a position at which the transfer roller can stably transfer the substrate WF. However, the transfer rollers 202 contact the substrate WF, and are therefore to be arranged so that the transfer rollers 202 contact a region of the substrate WF as a processing object in which no problem is caused by the contacting. The transfer rollers 202 of the load module 100 can be made of a conductive polymer. The transfer rollers 202 can be electrically grounded via the roller shafts 204 or the like. This is to prevent the substrate WF from becoming charged and the substrate WF from being damaged. Furthermore, an ionizer (not shown) may be provided in the load module 100 to prevent the substrate WF from becoming charged.

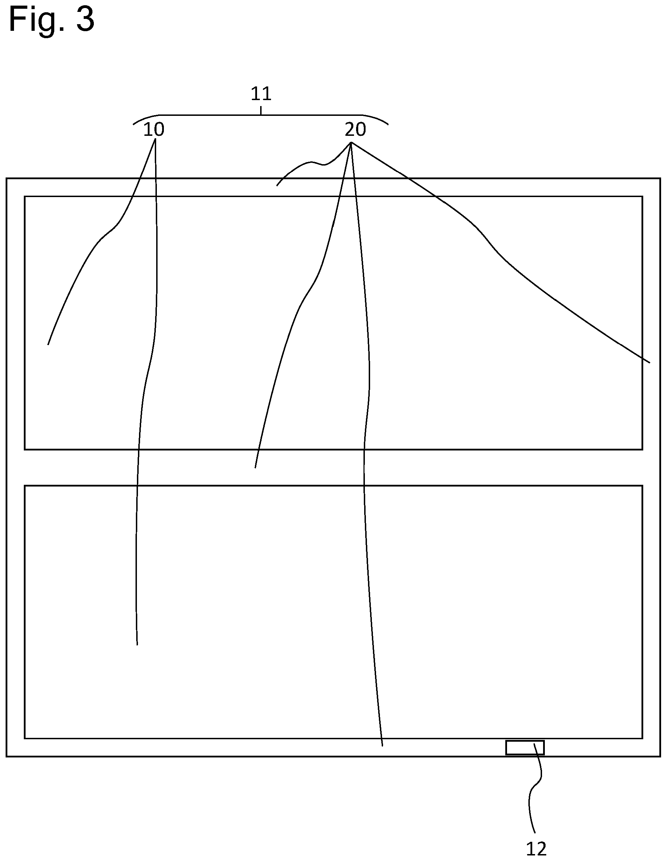

Fig. 3 is a plan view schematically showing the substrate WF that is the processing object. In the illustrated example, the substrate WF is a thin plate-shaped rectangular substrate having a substantially rectangular shape (including a square shape). The substrate WF includes a pattern region 10 and a non-pattern region 20 on a processing surface 11. The "pattern region" is a region including wiring, functional chips, and others, and is a region for use as a device formed on the substrate and provided with wiring, functional chips and others that are significant for the function of the device. Furthermore, the "non-pattern region" is a region that is not used as the device on the substrate. In the illustrated example, the substrate WF includes two pattern regions 10, and each pattern region 10 is surrounded by the non-pattern region 20. Furthermore, the substrate WF can include ID information of the substrate WF in non-pattern regions 20, and may include, for example, an ID tag 12. The ID of the substrate WF can be readable by an unshown ID reader disposed in the load module 100. A form of a back surface of the processing surface 11 of the substrate WF is not particularly limited.

The load module 100 accepts and transfers the substrate WF so that a surface of the substrate WF on which the pattern region 10 shown in Fig. 3 is formed is a lower surface. Therefore, the transfer rollers 202 are arranged to only contact the non-pattern regions 20 of the substrate WF. Specifically, as shown in Figs. 2 and 3, the transfer rollers 202 are provided at positions in contact with the non-pattern region 20 at an end of the substrate WF and at positions in contact with the central non-pattern region 20 of the substrate WF. The positions of the transfer rollers 202 can be changed depending on the substrate WF that is the processing object. Therefore, according to the illustrated embodiment, by changing the positions of the transfer rollers 202 mounted to the roller shaft 204, the rollers can be used to transfer the substrate WF having different dimensions and different patterns. The rectangular substrate has a dimension that is not determined by the standard as in a circular semiconductor substrate, and hence the substrate transfer mechanism 101 advantageously can transfer substrates with various dimensions by slight changes.

As shown in FIG. 2, the roller shafts 204 are rotationally driven by a motor 208 via gears 206. The motor 208 can be a servo motor. Use of the servo motor can control rotation speeds of the roller shafts 204 and the transfer rollers 202, that is, a transfer speed of the substrate WF. Furthermore, each gear 206 can be a magnet gear. The magnet gear is a non-contact power transmission mechanism, so that fine particles due to wear as in a contact gear are not generated, and maintenance such as supply of oil becomes unnecessary.

The substrate transfer mechanism 101 includes a plurality of guide rollers 212 for supporting the substrate WF in a direction of a width of the substrate WF to be transferred. Here, the width direction is perpendicular to a direction in which the substrate WF is transferred and is parallel to surfaces of the substrate WF. The guide rollers 212 are configured to support sides of the substrate WF being transferred. The guide rollers 212 are at positions that can be changed depending on the dimension of the substrate WF to be transferred. The shown guide rollers 212 are not connected to a power source and are configured to be freely rotatable. The guide rollers 212 may be configured to be at the positions that can be changed depending on the width of the substrate WF to be transferred.

The load module 100 is provided with auxiliary rollers 214 on an inlet side and an outlet side. Each auxiliary roller 214 is disposed at about the same height as the transfer roller 202. The auxiliary roller 214 is at a position that can be changed depending on the dimension of the substrate WF to be transferred. The auxiliary roller 214 supports the substrate WF so that the substrate WF being transferred does not fall between the module and the other module. The auxiliary rollers 214 are not connected to a power source and are configured to be freely rotatable. The load module 100 also includes an unshown sensor for detecting presence or absence of the substrate WF at a predetermined position on the transfer rollers 202. Based on the position of the substrate WF detected by the sensor, the transfer of the substrate WF is controlled.

In addition, a type, size, and shape of substrate WF are not particularly limited. The substrate WF can be a semiconductor substrate, in particular, a disk-shaped substrate or the rectangular substrate. The substrate WF is preferably the rectangular substrate. A demand for precision for quadrangular, rectangular substrates such as a copper clad laminate (CCL) substrate, a printed circuit board (PCB) substrate, a photomask substrate, and a display panel increases, and a clean substrate is required. However, the rectangular substrate is usually cleaned, for example, without being rotated when the rectangular substrate is transferred, so that the substrate is rubbed only from one direction by the cleaning member and cannot be sufficiently cleaned. In the substrate cleaning method of the present embodiment, the clean substrate can be provided by rubbing even the rectangular substrate from a plurality of directions with the cleaning member. Therefore, the rectangular substrate is preferably applied to the present embodiment. In an embodiment that follows, a case in which the substrate WF is the rectangular substrate will be described as an example.

<Transfer Module>

The substrate processing apparatus 1000 shown in Fig. 1 includes two transfer modules 200A and 200B. The two transfer modules 200A and 200B can include the same configuration, and hence the respective transfer modules will be collectively described as the transfer module 200 below. Furthermore, when referring to the polishing modules 300A and 300B without distinguishing from each other, each of the modules is referred to as the polishing module 300. The number of transfer modules 200 included in the substrate processing apparatus 1000 is not particularly limited, and one or more identical or different transfer modules 200 can be installed in the substrate processing apparatus 1000.

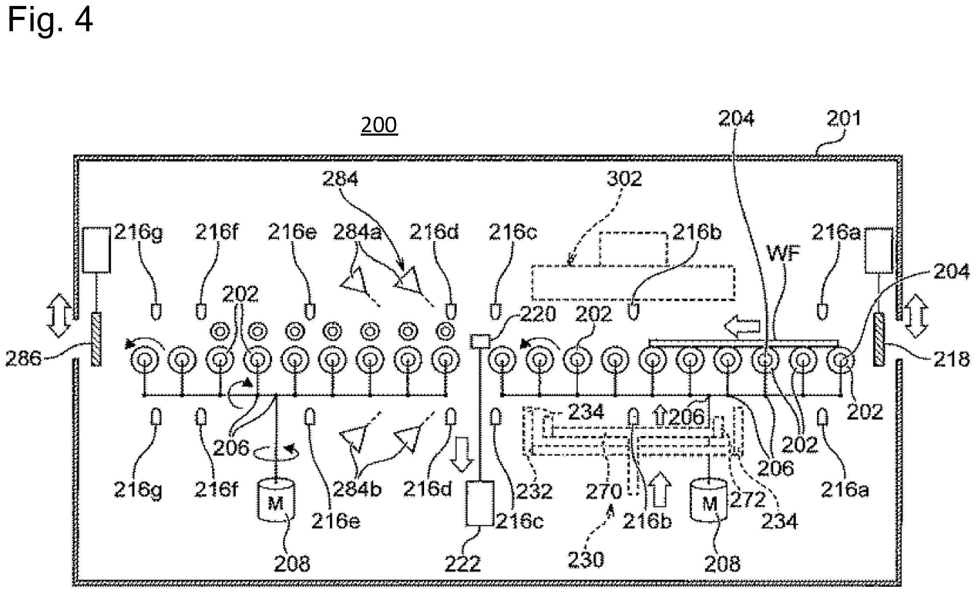

Fig. 4 is a cross-sectional view schematically showing a configuration of the transfer module 200. The transfer module 200 appropriately delivers and receives the substrate WF to and from the polishing module 300 while transferring the substrate WF. The transfer module 200 is disposed in the housing 201 and includes the plurality of transfer rollers 202 for transferring the substrate WF. The transfer module 200 can transfer the substrate WF on the transfer rollers 202 in a predetermined direction by rotating the transfer rollers 202. The transfer roller 202 of the transfer module 200 may be made of a conductive polymer or a non-conductive polymer. The transfer roller 202 is mounted to the roller shaft 204 and is driven by the motor 208 via the gear 206. The motor 208 can be a servo motor from the viewpoint of controlling the transfer speed. The gear 206 can be a magnet gear. In the illustrated example, the transfer module 200 includes a sensor 216 for detecting presence or absence of the substrate WF at a predetermined position on the transfer rollers 202. The sensor 216 can be any type of sensor, for example, an optical sensor. In the illustrated example, seven sensors 216 (216a to 216g) are provided in the transfer module 200, and the type and number of sensors 216 are not particularly limited. The control device 900 (Fig. 1) can control an operation of the transfer module 200 in response to the detection of the substrate WF by these sensors 216a to 216g. The transfer module 200 includes an inlet shutter 218 that can be opened and closed to accept the substrate WF in the transfer module 200. The transfer module 200 includes an outlet shutter 286 that can be opened and closed for transferring the substrate WF out of the transfer module 200.

The transfer module 200 includes a stopper 220. The stopper 220 is connected to a stopper moving mechanism 222, and the stopper 220 can enter a transfer path of the substrate WF moving on the transfer rollers 202. When the stopper 220 is located in the transfer path of the substrate WF, the side of the substrate WF moving on the transfer rollers 202 contacts the stopper 220, and the moving substrate WF can be stopped at the position of the stopper 220. Furthermore, when the stopper 220 is at a position retracted from the transfer path of the substrate WF, the substrate WF can move on the transfer rollers 202 without being hindered by the stopper 220. The position of the substrate WF stopped by the stopper 220 is a position at which a pusher 230 described later can receive the substrate WF on the transfer rollers 202.

The transfer module 200 includes the pusher 230. The pusher 230 is configured to lift the substrate WF on the plurality of transfer rollers 202 so that the substrate can separate from the plurality of transfer rollers 202. Furthermore, the pusher 230 is configured so that the substrate WF being held can be received and delivered to a top ring 302 of the polishing module 300.

The pusher 230 includes a first stage 232 and a second stage 270. The first stage 232 is a stage for supporting an unshown retainer member of the top ring 302 when the substrate WF is received from the pusher 230 and delivered to the top ring 302. The first stage 232 includes a plurality of support columns 234 for supporting the retainer member of the top ring 302. The second stage 270 is a stage for receiving the substrate WF on the transfer rollers 202. The second stage 270 includes a plurality of support columns 272 for receiving the substrate WF on the transfer rollers 202. The first stage 232 and the second stage 270 can be moved in a height direction perpendicular to the substrate WF by a first lifting mechanism. The second stage 270 can be further moved in the height direction relative to the first stage 232 by a second lifting mechanism. When the first stage 232 and the second stage 270 are raised by the first and second lifting mechanisms, parts of the support columns 234 of the first stage 232 and the support columns 272 of the second stage 270 pass between the transfer roller 202 and the roller shaft 204 and come to positions above the transfer rollers 202. The substrate WF transferred on the transfer roller 202 is stopped at the stop position by the stopper 220. Thereafter, the first stage 232 and the second stage 270 are raised by the first lifting mechanism, to lift the substrate WF on the transfer roller 202 by the support columns 272 of the second stage 270. Thereafter, while supporting the retainer member of the top ring 302 with the support columns 234 of the first stage 232, the second stage 270 holding the substrate WF is raised by the second lifting mechanism. The top ring 302 receives and holds the substrate WF on the second stage 270 by vacuum chucking.

The transfer module 200 includes a cleaner. This cleaner includes a cleaning nozzle 284. The cleaning nozzle 284 includes a top cleaning nozzle 284a disposed above the transfer rollers 202 and a bottom cleaning nozzle 284b disposed below. The top cleaning nozzle 284a and the bottom cleaning nozzle 284b are connected to an unshown supply source of a cleaning solution. The top cleaning nozzle 284a is configured to supply the cleaning solution to the upper surface of the substrate WF transferred on the transfer rollers 202. The bottom cleaning nozzle 284b is configured to supply the cleaning solution to the lower surface of the substrate WF transferred on the transfer rollers 202. The top cleaning nozzle 284a and the bottom cleaning nozzle 284b have a width equal to or larger than a width of the substrate WF transferred on the transfer roller 202 and are configured to clean an entire surface of the substrate WF when the substrate WF is transferred on the transfer rollers 202. The cleaner is located downstream of the stop position of the substrate WF, which is a substrate receiving and delivering location of the pusher 230.

The transfer module 200 receives the substrate WF polished by the polishing module 300 from the top ring 302, cleans the substrate appropriately, and then transfers the substrate out to the other transfer module 200 or the cleaning module 400. In the example of Fig. 1, the transfer module 200A transfers the substrate WF transferred in from the load module 100 out to the polishing module 300A and transfers the substrate WF polished by the polishing module 300A out to the transfer module 200B. Furthermore, the transfer module 200B transfers the substrate WF transferred in from the transfer module 200A out to the polishing module 300B and transfers the substrate WF polished by the polishing module 300B out to the cleaning module 400. The configuration of the transfer module 200 is not particularly limited, if the transfer module 200 can transfer the substrate WF out to the polishing module 300, transfer the substrate in from the polishing module 300 and transfer the substrate out to the other transfer module 200 or the cleaning module 400.

<Polishing Module>

The substrate processing apparatus 1000 shown in Fig. 1 includes two polishing modules 300A and 300B. The two polishing modules 300A and 300B can include the same configuration, and hence the respective modules will be collectively described as the polishing module 300 below. The number of polishing modules 300 included in the substrate processing apparatus 1000 is not particularly limited, and one or more identical or different polishing modules 300 can be installed in the substrate processing apparatus 1000.

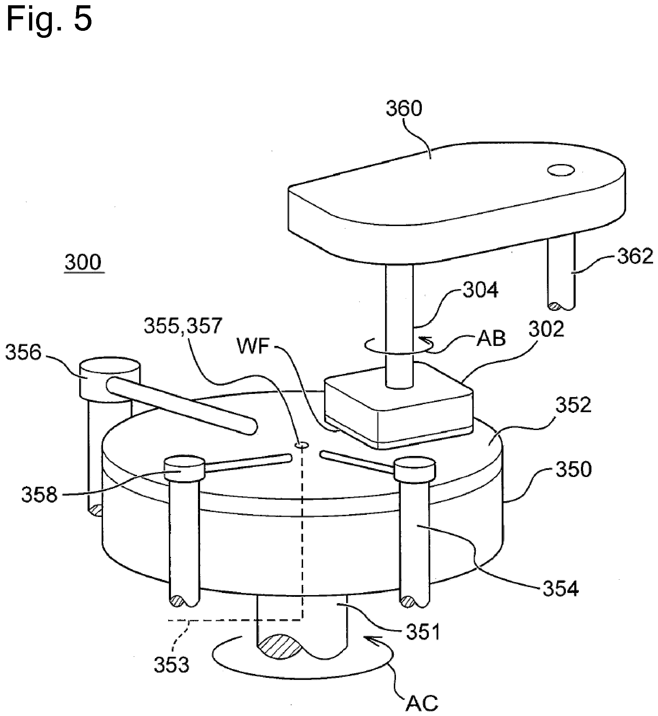

As shown in Fig. 5, the polishing module 300 includes a polishing table 350 and the top ring 302. The polishing table 350 is supported on a table shaft 351. The polishing table 350 is rotated about an axial center of the table shaft 351 by an unshown driver as indicated by an arrow AC. A polishing pad 352 is attached to the polishing table 350. The top ring 302 holds the substrate WF and presses the substrate onto the polishing pad 352.

The polishing module 300 includes a polishing solution supply nozzle 354 for supplying a polishing solution or dressing solution to the polishing pad 352. The polishing solution is, for example, slurry. The dressing solution is, for example, pure water. Furthermore, the polishing table 350 and the table shaft 351 include a passage 353 for supplying the polishing solution. The passage 353 communicates with an opening 355 on the surface of the polishing table 350. At a position corresponding to the opening 355 of the polishing table 350, the polishing pad 352 includes a through hole 357 formed, and the polishing solution through the passage 353 is supplied to the surface of the polishing pad 352 from the opening 355 of the polishing table 350 and the through hole 357 of the polishing pad 352. The polishing module 300 also includes a dresser 356 for conditioning the polishing pad 352. The polishing module 300 also includes an atomizer 358 for injecting a liquid or a mixed fluid of a liquid with a gas toward the polishing pad 352. The liquid injected from the atomizer 358 is, for example, pure water, and the gas is, for example, a nitrogen gas.

The top ring 302 is supported on a top ring shaft 304. The top ring 302 is rotated about an axial center of the top ring shaft 304 by an unshown driver as indicated by an arrow AB. Furthermore, the top ring shaft 304 can be moved vertically by an unshown drive mechanism.

The substrate WF is held by vacuum chucking on a surface facing the polishing pad 352 of the top ring 302. During polishing, the polishing solution is supplied to a polishing surface of the polishing pad 352 from the polishing solution supply nozzle 354 and/or from the through hole 357 of the polishing pad 352. Furthermore, during the polishing, the polishing table 350 and the top ring 302 are rotationally driven. The substrate WF is polished by pressing the substrate against the polishing surface of the polishing pad 352 by the top ring 302.

As shown in Fig. 5, the top ring shaft 304 is coupled to an arm 360, and the arm 360 can swing about a rotary shaft 362. During the polishing of the substrate WF, the arm 360 may be fixed or swung so that the top ring 302 passes through the center of the polishing pad 352. Furthermore, during the polishing of the substrate WF, the arm 360 may be fixed or swung so that the substrate WF covers the through hole 357 of the polishing pad 352. As shown in Fig. 1, the swingable arm 360 allows the top ring 302 to move toward the transfer module 200. The top ring 302 moves to the substrate receiving and delivering location of the transfer module 200, so that the top ring 302 can receive the substrate WF from the pusher 230. Furthermore, after polishing the substrate WF with the polishing module 300, the substrate WF can be received from the top ring 302 and delivered to the pusher 230.

Note that the configuration of the polishing module 300 is not particularly limited if the substrate WF can be polished or ground. For example, polishing or grinding may be performed using a polishing tape or a fixed abrasive surface plate. Furthermore, in the above example, face-down type polishing is performed on the substrate WF facing downward in a vertical direction, and alternatively, face-up type polishing may be performed on the substrate WF facing upward in the vertical direction.

<Cleaning Module>

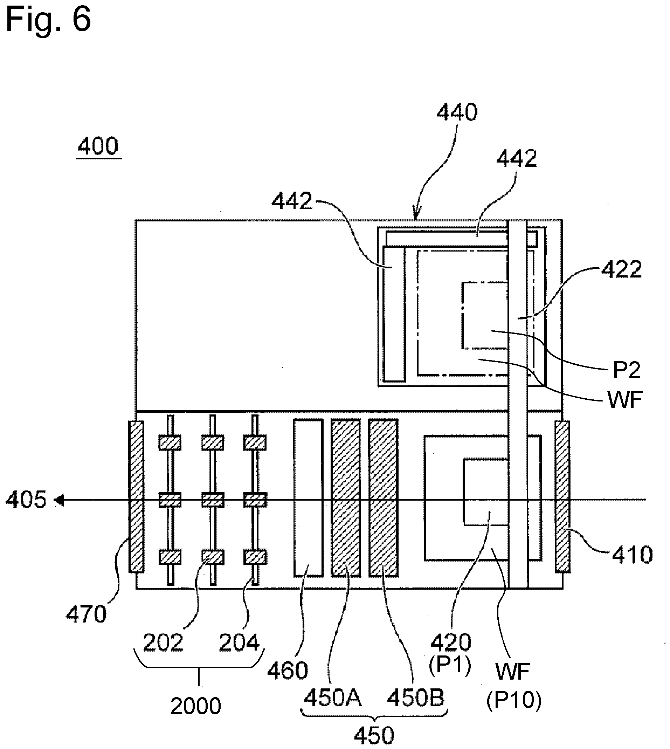

The substrate processing apparatus 1000 of the present embodiment includes the cleaning module 400 to remove, from the substrate WF, residue such as slurry that cannot be cleaned by a cleaning mechanism (top cleaning nozzle 284a and bottom cleaning nozzle 284b) of the transfer module 200. Fig. 6 is a plan view schematically showing the cleaning module 400. In addition, the cleaning module 400 and the control device 900 can be independently configured as a substrate cleaning apparatus.

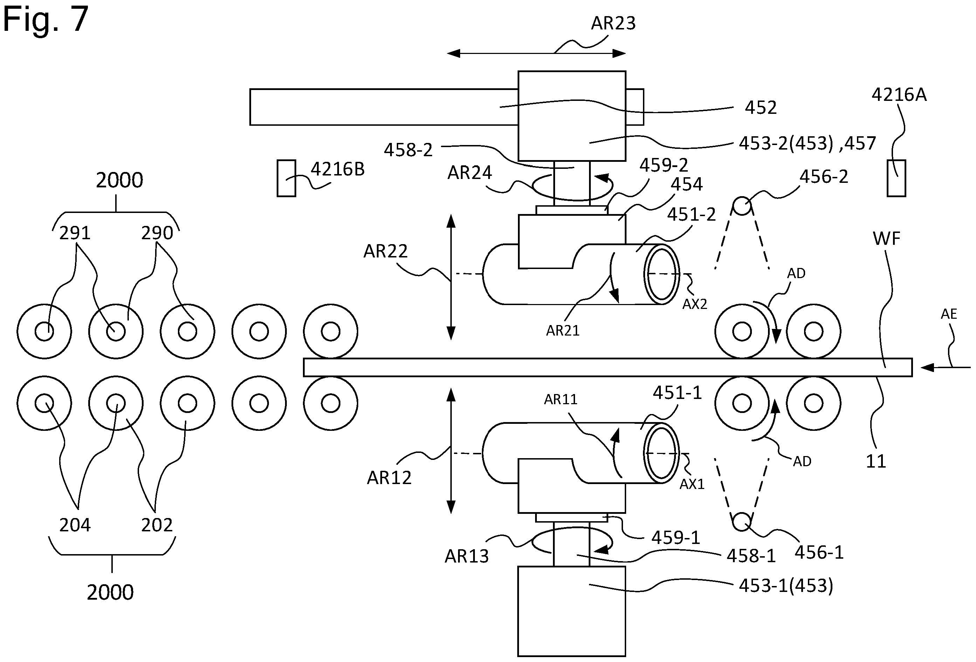

Into the cleaning module 400, the substrate WF polished by the polishing module 300 is transferred via an inlet shutter 410 with the processing surface 11 (Fig. 3) oriented downward. The cleaning module 400 includes a transfer mechanism 2000 including the transfer rollers 202 and the roller shafts 204, for transferring the substrate WF, in a state in which the surface to be polished is oriented downward, along a straight transfer path 405. In the transfer mechanism 2000, top transfer rollers 290 (Fig. 7) are arranged above the transfer rollers 202 in the vertical direction except for a position to receive and deliver the substrate WF to a transport machine 420 (substrate receiving and delivering position P10).

The transfer rollers 202 and top transfer rollers 290 of the cleaning module 400 can be made of a conductive polymer. The transfer rollers 202 and the top transfer rollers 290 are electrically grounded via the roller shafts 204, top transfer roller shafts 291 (Fig. 7), and the like. This is to prevent the substrate WF from becoming charged and the substrate WF from being damaged. The transfer rollers 202 and the top transfer rollers 290 are driven by the gears 206 and the motor 208 in the same manner as described in the transfer module 200, and detailed description of a structure and drive mechanism is therefore omitted.

The cleaning module 400 includes an ultrasonic cleaning tank 440 disposed at a position away from the transfer path 405 in a direction orthogonal to the transfer path 405. The ultrasonic cleaning tank 440 is a cleaning tank for cleaning the substrate WF in a state where the processing surface 11 is oriented downward. The ultrasonic cleaning tank 440 includes an ultrasonic irradiator 442 for applying ultrasonic waves to the substrate WF immersed in the cleaning solution stored in the ultrasonic cleaning tank 440. The ultrasonic cleaning tank 440 can clean residues such as slurry adhered to the processing surface 11 and back surface of the substrate WF by irradiating the surfaces with ultrasonic waves from the ultrasonic irradiator 442.

The cleaning module 400 includes the transport machine 420 for transporting the substrate WF from the substrate receiving and delivering position P10 on the transfer path 405 to the ultrasonic cleaning tank 440, and transporting the substrate WF cleaned in the ultrasonic cleaning tank 440 onto the transfer path 405. The transport machine 420 is configured to be movable between a transfer position P1 above the transfer path 405 and a cleaning position P2 above the ultrasonic cleaning tank 440. The transport machine 420 grips the substrate WF on the transfer path at the transfer position P1, lowers the substrate WF while gripping the substrate at the cleaning position P2, and immerses the substrate in the cleaning solution in the ultrasonic cleaning tank 440. After cleaning the substrate WF in the ultrasonic cleaning tank 440, the transport machine 420 moves to the transfer position P1 while gripping the substrate WF and releases the substrate WF onto the transfer path 405. Alternatively, the cleaning module 400 may include a plurality of ultrasonic cleaning tanks 440. This can increase types of usable cleaning solutions, therefore remove various residues adhered to the substrate WF and improve throughput of the cleaning module 400.

As shown in Fig. 6, the cleaning module 400 includes two scrub cleaning mechanisms 450A and 450B arranged downstream of the substrate receiving and delivering position P10 of the transfer path 405 in a substrate transfer direction. The two scrub cleaning mechanisms 450A and 450B can have the same configuration, and hence the respective mechanisms will be collectively described as the scrub cleaning mechanism 450 below. The scrub cleaning mechanism 450 performs scrub cleaning for cleaning the substrate WF by bringing a cleaning member into contact with the substrate WF and rubbing the substrate. The number of scrub cleaning mechanisms 450 included in the substrate processing apparatus 1000 is not particularly limited, and one or more identical or different scrub cleaning mechanisms 450 can be installed in the substrate processing apparatus 1000.

Fig. 7 is a side view schematically showing the scrub cleaning mechanism 450. Hereinafter, a direction in which the substrate WF is transferred is referred to as a transfer direction (schematically indicated by arrow AE), and a direction of rotation axis AX1 or AX2 of the cleaning member 451 is referred to as an axial direction. The transfer direction and axial direction are appropriately referred to as a first direction and a second direction, respectively. From the viewpoint of providing the clean substrate WF more reliably, the transfer direction and axial direction are preferably directions along the surface of the substrate WF, more preferably directions substantially parallel to the surface of the substrate WF, and further preferably directions parallel to the surface of the substrate WF. The substrate WF is transferred along the transfer direction between the transfer roller 202 mounted to the roller shaft 204 and the top transfer roller 290 mounted to the top transfer roller shaft 291. The substrate WF is driven in the transfer direction by rotation (arrow AD) of the transfer rollers 202 or the top transfer rollers 290. The scrub cleaning mechanism 450 performs cleaning by bringing, into contact with the substrate WF transferred in the transfer direction, cleaning members 451-1 and 451-2 rotating about the respective rotation axes AX1 and AX2 extending in the axial direction that is not perpendicular to the transfer direction along the processing surface 11 of the substrate WF. The cleaning members 451-1 and 451-2 can be roll cleaning members for performing scrub cleaning of the surface of the substrate WF while rotating.

The scrub cleaning mechanism 450 includes a first cleaning member 451-1 that contacts the processing surface 11 of the substrate WF transferred by the transfer mechanism 2000 and rotates at a predetermined number of revolutions (schematically indicated by arrow AR11) by an unshown rotation mechanism, and a lifting mechanism 453-1 for raising and lowering the first cleaning member 451-1 via a load cell 459-1 (schematically indicated by arrow AR12). Furthermore, the scrub cleaning mechanism 450 includes a second cleaning member 451-2 contacting the back surface of the substrate WF transferred by the transfer mechanism 2000 and rotating at a predetermined number of revolutions by an unshown rotation mechanism (schematically indicated by arrow AR21), and a roll holder 454 for holding the second cleaning member 451-2. The scrub cleaning mechanism 450 further includes a lifting mechanism 453-2 for raising and lowering the second cleaning member 451-2 (schematically indicated by arrow AR22) via a load cell 459-2 mounted to the roll holder 454, and a horizontal drive mechanism 457 for driving the second cleaning member 451-2 along a shaft 452 extending parallel to the transfer path 405 (schematically indicated by arrow AR23). The first cleaning member 451-1 and the second cleaning member 451-2 are arranged opposite to each other via the transfer mechanism 2000. The lifting mechanisms 453-1 and 453-2 and the horizontal drive mechanism 457 can be implemented by a known mechanism such as a motor. The lifting mechanisms 453-1 and 453-2 may raise and lower the first cleaning member 451-1 and the second cleaning member 451-2 vertically symmetrically relative to the substrate WF, respectively, or may raise and lower the cleaning members individually. Hereinafter, when referring to the lifting mechanisms 453-1 and 453-2 without distinguishing from each other, each of the mechanisms is referred to as the lifting mechanism 453. Alternatively, the first cleaning member 451-1 may be moved in a direction along the substrate WF by disposing a horizontal drive mechanism. Alternatively, one horizontal drive mechanism 457 may allow both the first cleaning member 451-1 and the second cleaning member 451-2 to move in the direction along the substrate WF. If the cleaning member having a desired rotation axis angle θ (described later) can be brought into contact with and separated from the substrate WF, the cleaning member can be appropriately movable.

The first cleaning member 451-1 and the second cleaning member 451-2 are not particularly limited to any form if the members can rotate about the rotation axes AX1 and AX2 extending in a predetermined direction and contact the substrate WF to clean the substrate WF. The first cleaning member 451-1 and the second cleaning member 451-2 are preferably cylindrical from the viewpoint of efficiently rubbing the substrate WF by rotation. From the same viewpoint, the first cleaning member 451-1 and the second cleaning member 451-2 are preferably axially extending sponges or brushes, and more preferably cylindrical sponges or brushes. The sponge is particularly preferable because of its excellent flexibility, elasticity, water absorption, and the like. Hereinafter, when referring to the first cleaning member 451-1 and the second cleaning member 451-2 without distinguishing from each other, each of the members are appropriately referred to as the cleaning member 451. When referring to the rotation axis AX1 of the first cleaning member 451-1 and the rotation axis AX2 of the second cleaning member 451-2 without distinguishing from each other, each of the axes are appropriately referred to as the rotation axis AX. Each cleaning member 451 may have a cylindrical inner circumferential surface, the inner circumferential surface being mounted to an outer circumferential surface of an unshown columnar core member having the rotation axis AX as a rotation center line, and the cleaning member 451 may be configured to rotate integrally with the core member.

The scrub cleaning mechanism 450 includes a first sensor 4216A and a second sensor 4216B. The first sensor 4216A and the second sensor 4216B detect the position of the substrate WF. If the substrate WF can be detected, the first sensor 4216A and the second sensor 4216B are not particularly limited to any type and can be optical sensors or the like. A detection signal generated by detecting the substrate WF by the first sensor 4216A and the second sensor 4216B is transmitted to the control device 900 and analyzed. Alternatively, the first sensor 4216A and the second sensor 4216B may analyze the detection signal, generate data, and transmit the data to the control device 900.

The load cell 459-1 is a measuring instrument that measures a force with which the lifting mechanism 453-1 presses the first cleaning member 451-1 against the substrate WF. The load cell 459-2 is a measuring instrument that measures a force with which the lifting mechanism 453-2 presses the second cleaning member 451-2 against the substrate WF. When the first cleaning member 451-1 and the second cleaning member 451-2 are individually raised and lowered, the scrub cleaning mechanism 450 is configured to control, in a closed loop, the pressing force of the first cleaning member 451-1 onto the substrate WF based on a measured value of the load cell 459-1. Similarly, the second cleaning member 451-2 is controlled in the closed loop based on the measured value of the load cell 459-2. For example, the scrub cleaning mechanism 450 can control the positions of the first cleaning member 451-1 and the second cleaning member 451-2 so that the measured values of the load cells 459-1 and 459-2 are preset specific values. Furthermore, when the first cleaning member 451-1 and the second cleaning member 451-2 are raised and lowered vertically symmetrically relative to the substrate WF, the scrub cleaning mechanism 450 may refer to the load cell 459-1 or 459-2 as the measured value for use in the closed-loop control. However, if referring to either one of the load cells 459-1 and 459-2, a situation may not be detected in which the substrate WF abuts only on one of the first cleaning member 451-1 and the second cleaning member 451-2 due to warp or the like. For example, when the closed-loop control is performed based on the measured value of the load cell 459-2, the scrub cleaning mechanism 450 cannot detect that the substrate WF is not in contact with the first cleaning member 451-1 or that a top surface of the substrate WF cannot be cleaned. To solve the problem, the scrub cleaning mechanism 450 can control the positions of the first cleaning member 451-1 and the second cleaning member 451-2 based on an average value of the measured values of the load cells 459-1 and 459-2. In this case, when the substrate WF abuts only on one cleaning member, the measured value of one of the load cells 459-1 and 459-2 becomes 0, and the average value of the measured values is also reduced to half. Then, the scrub cleaning mechanism 450 controls the pressing force by bringing the first cleaning member 451-1 and the second cleaning member 451-2 closer to the substrate WF. As a result, the substrate WF can be recovered from the situation in which the substrate abuts only on one cleaning member, and the scrub cleaning mechanism 450 can clean both top and bottom surfaces of the substrate WF. Furthermore, the scrub cleaning mechanism 450 can perform feedback control of the positions of the first cleaning member 451-1 and the second cleaning member 451-2 if a difference between the measured value of each of the load cells 459-1 and 459-2 and the preset specific value exceeds a threshold value. This is because hunting may occur when the feedback control is performed even though the difference between the measured value of each of the load cells 459-1 and 459-2 and the preset specific value is small. Furthermore, it is considered that the measured values of the load cells 459-1 and 459-2 may include, as noise, a difference in level between the first cleaning member 451-1 and the second cleaning member 451-2 and vibration of the substrate WF, and hence the scrub cleaning mechanism 450 may obtain a moving average of the measured values for use in position control.

The scrub cleaning mechanism 450 includes a plurality of first cleaning nozzles 456-1 for injecting a cleaning solution onto the surface to be polished of the substrate WF when cleaning the substrate WF with the first cleaning member 451-1. Furthermore, the scrub cleaning mechanism 450 includes a plurality of second cleaning nozzles 456-2 for injecting a cleaning solution onto the back surface of the substrate WF when cleaning the substrate WF with the second cleaning member 451-2. In addition to a configuration in which the cleaning solution is supplied from the first cleaning nozzles 456-1 and the second cleaning nozzles 456-2, the cleaning solution or rinse solution may be passed through the cleaning member 451 via a liquid passage of the above-described core member disposed inside the cleaning member 451 and supplied from an outer circumferential surface of the cleaning member 451.

The scrub cleaning mechanism 450 may also include an unshown cleaning mechanism for contacting the first cleaning member 451-1 and cleaning the first cleaning member 451-1. In one example, the cleaning mechanism can be made of a quartz plate for removing dirt such as dust adhered to the first cleaning member 451-1 by contacting the first cleaning member 451-1 but is not limited thereto. A cleaning mechanism may be installed in the same manner for the second cleaning member 451-2.

The direction of the rotation axis AX1 of the first cleaning member 451-1 is variable. The first cleaning member 451-1 is configured to be rotatable about an axis perpendicular to the processing surface 11 of the substrate WF (schematically indicated by arrow AR13). The first cleaning member 451-1 is rotated by an unshown rotation mechanism such as a servo mechanism and is configured so that the rotation axis AX1 is changeable to one of a plurality of continuous or discrete directions. For example, in the first cleaning member 451-1, a first shaft 458-1 having a central axis perpendicular to the processing surface 11 of the substrate WF can rotate about the central axis. The direction of the rotation axis AX1 is changed under control of a cleaning controller 952 of the control device 900 described later.

The direction of the rotation axis AX2 of the second cleaning member 451-2 is variable. The second cleaning member 451-2 is configured to be rotatable about an axis perpendicular to the processing surface 11 of the substrate WF (schematically indicated by arrow AR24). The second cleaning member 451-2 is rotated by an unshown rotation mechanism such as a servo mechanism and is configured so that the rotation axis AX2 is changeable to one of a plurality of continuous or discrete directions. For example, in the second cleaning member 451-2, a second shaft 458-2 having a central axis perpendicular to the processing surface 11 of the substrate WF can rotate about the central axis. The direction of the rotation axis AX2 is changed under control of the cleaning controller 952 of the control device 900 described later.

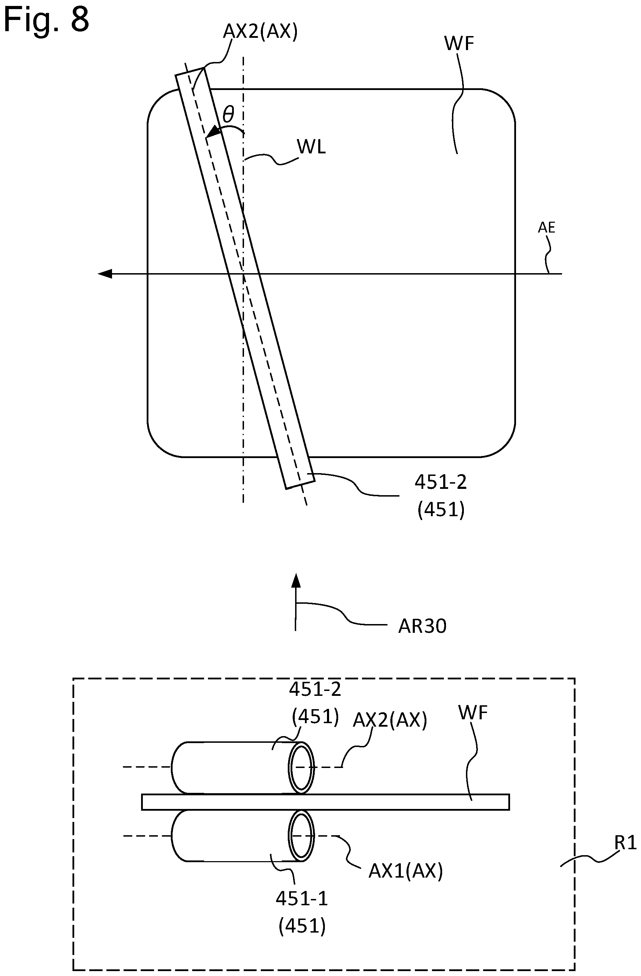

Fig. 8 is a conceptual diagram schematically showing the first cleaning member 451-1, the second cleaning member 451-2, and the substrate WF. A portion that is not surrounded by a rectangle R1 of Fig. 8 shows a plan view schematically showing the first cleaning member 451-1, the second cleaning member 451-2, and the substrate WF. A portion surrounded by the rectangle R1 shows a side view schematically showing the first cleaning member 451-1, the second cleaning member 451-2, and the substrate WF as viewed from a direction of arrow AR30.

The rotation axis AX2 of the second cleaning member 451-2 forms an angle $\theta$ with a line WL perpendicular to the transfer direction (arrow AE) on a plane along the substrate WF. This angle is a rotation axis angle $\theta$. The rotation axis angle $\theta$ is defined in a range of 0 degrees or more and less than 360 degrees. Description will be made as follows on the assumption that both the rotation axis AX1 of the first cleaning member 451-1 and the rotation axis AX2 of the second cleaning member 451-2 form the same rotation axis angle $\theta$ relative to a direction perpendicular to the transfer direction. The rotation axis angle $\theta$ can be changed to a plurality of angles and can be set in at least one direction that is not perpendicular to the transfer direction. Furthermore, from the viewpoint of efficiently performing the scrub cleaning of the substrate WF, it is preferable that the rotation axis angle $\theta$ can be set in a direction that is neither perpendicular nor parallel to the transfer direction. From the same point of view, the rotation axis angle $\theta$ is preferably between 1 degree and 45 degrees, between 135 degrees and 179 degrees, between 181 degrees and 225 degrees or between 315 degrees and 359 degrees, and further preferably between 5 degrees and 45 degrees, between 135 degrees and 175 degrees, between 185 degrees and 225 degrees or between 315 degrees and 355 degrees. This also holds for a case in which the rotation axis angle $\theta$ is set to an angle that is not 0 degrees or not 180 degrees. Alternatively, the rotation axis angle of the first cleaning member 451-1 and the rotation axis angle of the second cleaning member 451-2 may be different angles, and the respective rotation axis angles may be controlled independently.

In the present embodiment, the control device 900 controls and changes a cleaning condition including at least one of the directions of the rotation axes AX1 and AX2 determined by the rotation axis angle $\theta$, the rotation speeds of the first cleaning member 451-1 and the second cleaning member 451-2, and the transfer speed of the substrate.

In the following embodiment, when the "rotation speed" is described for the cleaning member 451, it refers to the rotation speed of rotation about the rotation axis AX unless otherwise noted. When "changing the rotation axis angle $\theta$" or "changing the direction of the rotation axis AX" of the cleaning member 451 is described, at least an angle formed by a component of the rotation axis AX along the processing surface 11 of the substrate WF with respect to the width direction (direction perpendicular to the transfer direction) of the substrate WF is changed. To change the rotation axis angle $\theta$, the cleaning member 451 may be moved along the substrate WF, and alternatively, after the cleaning member 451 is raised to a certain height, the cleaning member 451 may be rotated about the axis perpendicular to the substrate WF and brought into contact with the substrate WF again. If the rotation axis angle $\theta$ can be changed, an intermediate operation is not particularly limited.

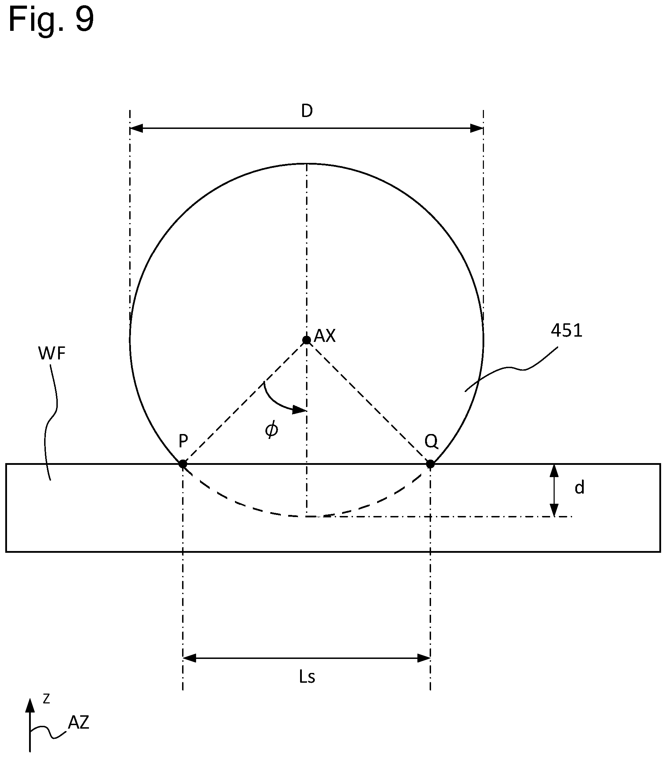

Fig. 9 is a conceptual diagram for describing efficiency of cleaning by the cleaning member 451 on the surface of the substrate WF. Hereinafter, a length with which a certain point on the surface of the cleaning member 451 rubs the substrate WF while the cleaning member 451 rotates once is referred to as a rubbing length, and a direction in which the certain point rubs the substrate is referred to as a rubbing direction. To increase the efficiency of cleaning, it is desirable to rub the substrate WF from a plurality of rubbing directions with a longer rubbing length.

It is assumed that the cleaning member 451 is a cylindrical sponge, and a diameter of a cross section perpendicular to the rotation axis AX is D. The largest length of the sponge that is pressed in a radial direction in contact with the substrate WF is a push length d. In the sponge, a width of the sponge in contact with the substrate WF in the direction along the substrate WF perpendicular to the rotation axis AX is Ls. Opposite points of the width are points P and Q, respectively. An angle of 1/2 of a central angle corresponding to a portion in contact with the substrate WF from point P to point Q about the rotation axis AX is denoted with $\phi$. Take X axis parallel to the transfer direction, take Z axis perpendicular to the surface to be cleaned of the substrate WF (see arrow AZ), and take Y axis perpendicular to the X axis and Z axis. The transfer speed of the substrate is denoted with v. The rotation speed of the sponge is denoted with R.

At this time, an amount L of movement of a certain point (for example, P) on the surface of the sponge on the substrate during one rotation of the sponge is represented as L (Lx, Ly) by XY coordinates. Then, X component Lx of the amount L of movement is a sum of X component Lsx of the amount of movement contributed by the rotation of the sponge and X component Lv of the amount of movement contributed by the movement of the substrate WF. Y component Ly of the amount L of movement is Y component Lsy of the amount of movement contributed by the rotation of the sponge. Therefore, the components are described in equations (1) and (2) as follows. In the following equation (1) to (9), the rotation speed R of the sponge is the number of revolutions per minute, and the other variables are expressed in MKSA unit system.

$$Lx=Lsx+Lv \ ... \ (1)$$

$$Ly=Lsy \ ... \ (2)$$

Here, Lsx and Lsy are X and Y components of a vector corresponding to the width Ls (Fig. 9). The width Ls is calculated by the following equation (3) from the diameter D of the cross section of the sponge and the push length d. Therefore, Lsx and Lsy are calculated by the following equations (4) and (5). The X component Lv of the amount of movement contributed by the movement of the substrate WF during one rotation of the sponge is calculated by the following equation (6) using the transfer speed v, the angle $\phi$, and the sponge rotation speed R. The angle $\phi$ is calculated by the following equation (7) from the diameter D of the cross section of the sponge and the push length d.

$$Ls=2((D/2)^2-(D/2-d)^2)^{0.5}=2((D-d)\times d)^{0.5} \ ... \ (3)$$

$$Lsx=Ls\times\cos\theta \ ... \ (4)$$

$$Lsy=Ls\times\sin\theta \ ... \ (5)$$

$$Lv=v\times(2\phi)/(2\pi R/60) \ ... \ (6)$$

$$\phi=\cos^{-1}(1-d/(D/2)) \ ... \ (7)$$

When the equations (3) to (7) are applied to the above-described equations (1) and (2), it can be derived that Lx and Ly are calculated by the following equations (8) and (9).

$$Lx=2((D-d)\times d)^{0.5}\times\cos\theta+60v/(\pi R)\times\cos^{-1}(1-d/(D/2)) \ ... \ (8)$$

$$Ly=2((D-d)\times d)^{0.5}\times\sin\theta \ ... \ (9)$$

It is seen from the equations (8) and (9) that by changing the rotation axis angle $\theta$ of the cleaning member 451, the rotation speed R of the cleaning member 451, or the transfer speed v of the substrate WF, a ratio of Lx and Ly changes, and a direction in which each portion of the cleaning member 451 rubs the substrate WF (rubbing direction) accordingly changes. Therefore, in the present embodiment, the cleaning member 451 can provide a cleaner substrate WF by rubbing the substrate WF from a plurality of rubbing directions.

As above, it has been described that the rotation axis angle $\theta$ of the first cleaning member 451-1 and the rotation axis angle $\theta$ of the second cleaning member 451-2 are the same. In this case, when the first cleaning member 451-1 and the second cleaning member 451-2 are arranged opposite to each other via the substrate WF, a force is applied to the same position on a plane (XY plane) parallel to the substrate WF. This is preferable because no moment is generated, and cleaning can be performed stably. However, the scrub cleaning mechanism 450 can perform scrub cleaning with any number of cleaning members 451 having the same or different rotation axis angles $\theta$.

As shown in Figs. 1 and 6, the cleaning module 400 includes a rinse cleaning mechanism 460 disposed downstream of the scrub cleaning mechanism 450 along the transfer path 405 in the substrate transfer direction. The rinse cleaning mechanism 460 includes an unshown rinse solution supply nozzle for supplying a rinse solution (for example, pure water) to the processing surface 11 of the substrate WF cleaned by the scrub cleaning mechanism 450. The substrate WF is cleaned with the rinse solution by the rinse cleaning mechanism 460. The substrate WF cleaned by the rinse cleaning mechanism 460 is transferred out of the cleaning module 400 via an outlet shutter 470 shown in Fig. 6 and transferred into the drying module 500. In the present embodiment, an example has been described in which both ultrasonic cleaning by the ultrasonic cleaning tank 440 and scrub cleaning by the scrub cleaning mechanism 450 are performed on the substrate WF, and then rinse cleaning by the rinse cleaning mechanism 460 is performed but is not limited thereto. The cleaning module 400 may omit at least one of the ultrasonic cleaning and the rinse cleaning depending on the material of the substrate WF, type of dirt adhered to the substrate WF, the size of the substrate WF, and the like. The ultrasonic cleaning tank 440 and the scrub cleaning mechanism 450 may also include a system for supplying a chemical solution. This can achieve the cleaning module 400 capable of using both of physical and chemical cleaning methods.

<Drying Module>

Returning to Fig. 1, the drying module 500 is an apparatus for drying the substrate WF. In the illustrated substrate processing apparatus 1000, the drying module 500 dries the substrate WF cleaned by the cleaning module 400. The drying module 500 is disposed downstream of the cleaning module 400.

The drying module 500 includes nozzles 530 for injecting gas toward the substrate WF. This gas can be compressed air or nitrogen. In the drying module 500, the substrate WF is transferred by the transfer rollers 202 mounted to the roller shafts 204. During this transfer, gas is injected from the nozzles 530 toward the substrate WF and the substrate WF is dried. The substrate WF transferred out of the drying module 500 is transferred into the unload module 600. Note that a configuration of the drying module 500 is not particularly limited if the substrate WF can be dried to a desired degree.

<Unload Module>

The unload module 600 is a unit for transferring the substrate WF polished and cleaned or otherwise processed out of the substrate processing apparatus 1000. In the unload module 600, the substrate WF is transferred by the transfer rollers 202 mounted to the roller shafts 204. The unload module 600 includes an unshown sensor and can be configured to transfer the substrate WF out of the substrate processing apparatus 1000 when detecting the substrate WF with the sensor. Note that the unload module 600 is not particularly limited to any form if the substrate WF can be transferred out of the substrate processing apparatus 1000.

<Control Device>

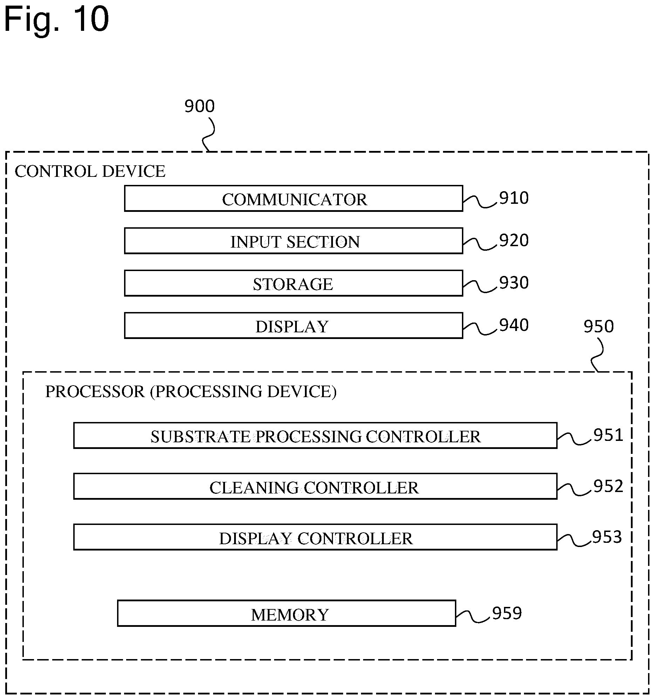

Fig. 10 is a conceptual diagram schematically showing a configuration of the control device 900. The control device 900 includes a communicator 910, an input section 920, a storage 930, a display 940, and a processor 950. The processor 950 includes a substrate processing controller 951, a cleaning controller 952, a display controller 953, and a memory 959.

The control device 900 includes an information processing device such as a general computer or a dedicated computer, interfaces with a user (hereinafter simply referred to as a user) of the substrate processing apparatus 1000 as appropriate, and performs processing such as communicating, storing, and computing for various data. Alternatively, the control device 900 may include each component disposed in a physically different device. Furthermore, at least part of the data processed by the control device 900 may be stored on a remote server or the like.

The communicator 910 includes a communication device that can communicate by wireless or wired connection. The communicator 910 receives data required for processing by the processor 950 and transmits the data obtained in the processing.

The input section 920 includes an input device such as a mouse, a keyboard, various buttons, or a touch panel. The input section 920 accepts, from the user, input required for an operation of the substrate processing apparatus 1000.

The storage 930 includes a non-volatile or volatile storage medium. The storage 930 stores programs and data for the processor 950 to execute the processing.

The display 940 includes a display device such as a liquid crystal monitor. The display 940 displays information or the like obtained by the processing of the processor 950.

The processor 950 includes a processing device including a processing unit such as a CPU. The processor 950 functions as a performer of an operation of controlling the substrate processing apparatus 1000. The processor 950 performs several types of processing by reading the program stored in the storage 930 or the like into a memory 959 and executing the program. This program includes the processing performed by the processor 950 as described below. This program may be acquired from a recording medium such as a DVD-ROM or may be acquired via a network. The processor 950 includes a physical configuration that is not limited if the processing by the processor 950 is possible.

The substrate processing controller 951 controls each component of the substrate processing apparatus 1000 for performing processing such as polishing for the substrate WF. The substrate processing controller 951 controls the load module 100 and the unload module 600 to transfer the substrate WF into the substrate processing apparatus 1000 and out of the substrate processing apparatus 1000. Furthermore, the substrate processing controller controls the transfer modules 200A and 200B or the like and controls the transfer of the substrate WF. The substrate processing controller 951 controls the transfer module 200A and moves the substrate WF to the substrate receiving and delivering location of the transfer module 200A. The substrate processing controller 951 controls the polishing module 300A, polishes the substrate WF from the substrate receiving and delivering location, and returns the substrate to the substrate receiving and delivering location. In the present embodiment, the substrate processing controller 951 also functions as a polishing controller. The substrate processing controller 951 controls the transfer modules 200A and 200B and moves the substrate WF to the substrate receiving and delivering location of the transfer module 200B. The substrate processing controller 951 controls the polishing module 300B, polishes the substrate WF from the substrate receiving and delivering location, and returns the substrate to the substrate receiving and delivering location. The substrate processing controller 951 controls the transfer module 200B and moves the substrate WF to the cleaning module 400.

The cleaning controller 952 controls the cleaning module 400 to clean the substrate WF. The cleaning controller 952 controls the transport machine 420 (Fig. 6) and the ultrasonic cleaning tank 440 to ultrasonically clean the substrate WF at the substrate receiving and delivering position P10. The cleaning controller 952 controls the scrub cleaning mechanisms 450A and 450B to perform the scrub cleaning of the substrate WF. The cleaning controller 952 controls the rinse cleaning mechanism 460 to perform the rinse cleaning of the substrate WF. The cleaning controller 952 controls the transfer mechanism 2000 and transfers the substrate WF out to the drying module.

Hereinafter, the control of the scrub cleaning mechanism 450 by the cleaning controller 952 will be described. The cleaning controller 952 receives a detection signal indicating the detection of the substrate WF from the first sensor 4216A (Fig. 7) disposed upstream of the cleaning member 451. On receiving the detection signal from the first sensor 4216A, the cleaning controller 952 starts the scrub cleaning.

The cleaning controller 952 sets the rotation axis angle $\theta$ of the cleaning member 451. The cleaning controller 952 can refer to a value of the rotation axis angle $\theta$ stored in advance in the storage 930 or the like. Alternatively, the cleaning controller 952 may calculate and set the rotation axis angle $\theta$ based on the rotation speed of the cleaning member 451 or the transfer speed of the substrate WF. For example, the cleaning controller 952 can calculate and set the rotation axis angle $\theta$ based on the above-described equations (8) and (9) to achieve the desired rubbing length in the desired rubbing direction.

The cleaning controller 952 controls the scrub cleaning mechanism 450 to achieve the set rotation axis angle $\theta$. The cleaning controller 952 controls an unshown rotation mechanism, rotates the cleaning member 451 about an axis perpendicular to the substrate WF, and causes the rotation axis angle $\theta$ to be a set value. When the rotation for achieving the rotation axis angle $\theta$ is completed, the cleaning controller 952 rotates the cleaning members 451 about the rotation axes AX. The cleaning controller 952 controls the lifting mechanism 453 to bring the cleaning members 451 into contact with the substrate WF and performs the scrub cleaning. Alternatively, the cleaning controller 952 may control the shaft 452 and the horizontal drive mechanism 457 to move the second cleaning member 451-2 in the direction along the substrate WF.

The cleaning controller 952 changes the cleaning condition based on information about at least one of the substrate WF and the cleaning module 400. This information is referred to as cleaning information. The cleaning information can include information indicating the position or state of the substrate WF or a state of a component of the cleaning module 400. Furthermore, the cleaning condition is a condition during the cleaning by the cleaning module 400, including at least one of the rotation axis angle $\theta$ or the direction of the rotation axis AX of the cleaning member 451, the rotation speed of the cleaning member 451, and the transfer speed of the substrate WF.

When the rotation axis angle $\theta$ of the cleaning member 451 is changed, the cleaning controller 952 controls the lifting mechanism 453 to temporarily separate the cleaning member 451 in a direction perpendicular to the substrate WF. Thereafter, the cleaning controller 952 rotates the cleaning member 451 about an axis perpendicular to the substrate WF. Subsequently, the cleaning controller 952 controls the lifting mechanism 453 to bring the cleaning member 451 into contact with the substrate WF and to perform the scrub cleaning again. Alternatively, the rotation axis angle θ may be changed while the cleaning member 451 is in contact with the substrate WF. When the rotation speed of the cleaning member 451 is changed, the cleaning controller 952 controls a motor, which drives rotation of the cleaning member 451 about the rotation axis AX, to change the rotation speed. When the transfer speed of the substrate WF is changed, the cleaning controller 952 controls the transfer mechanism 2000 to change the transfer speed.

The cleaning controller 952 can change the cleaning condition based on whether the components of the cleaning module 400 are operating normally. For example, the cleaning controller 952 changes the cleaning condition based on a drive current or drive torque of a motor that drives the transfer mechanism 2000 of the substrate WF or the motor that drives the rotation of the cleaning member 451 about the rotation axis AX. When the drive current or drive torque indicates an abnormal value indicating deviation from a predetermined range, the cleaning controller 952 can slow down the transfer speed of the substrate WF, slow down the rotation speed of the cleaning member 451, and change the rotation axis angle θ of the cleaning member 451. This configuration can reduce damages on the cleaning member 451, the cleaning module 400, and the substrate WF. The cleaning controller 952 can determine whether to change the cleaning condition based on a threshold value of the drive current or drive torque stored in advance in the storage 930 or the like, and a measured value of the drive current or drive torque. For example, the cleaning controller 952 can determine to change the cleaning condition if the measured drive current or drive torque is larger than the threshold value. In the following determination, if the determination is performed based on the threshold value, its algorithm is not particularly limited.

The cleaning controller 952 receives a detection signal indicating the detection of the substrate WF from the second sensor 4216B (Fig. 7) disposed downstream of the cleaning member 451. On receiving the detection signal from the second sensor 4216B, the cleaning controller 952 completes the scrub cleaning. The cleaning controller 952 controls the lifting mechanism 453 to separate the cleaning member 451 from the substrate WF. The cleaning controller 952 can clean the cleaning member 451 with an unshown cleaning mechanism or retract the member to a retracted position at which the cleaning is not performed.

The display controller 953 controls the display 940, to display information on the substrate processing apparatus 1000 on a display device. The display controller 953 can display information on the cleaning of the substrate WF, such as the rotation axis angle θ or rotation speed of the cleaning member 451 and the transfer speed of the substrate WF in the scrub cleaning mechanism 450.

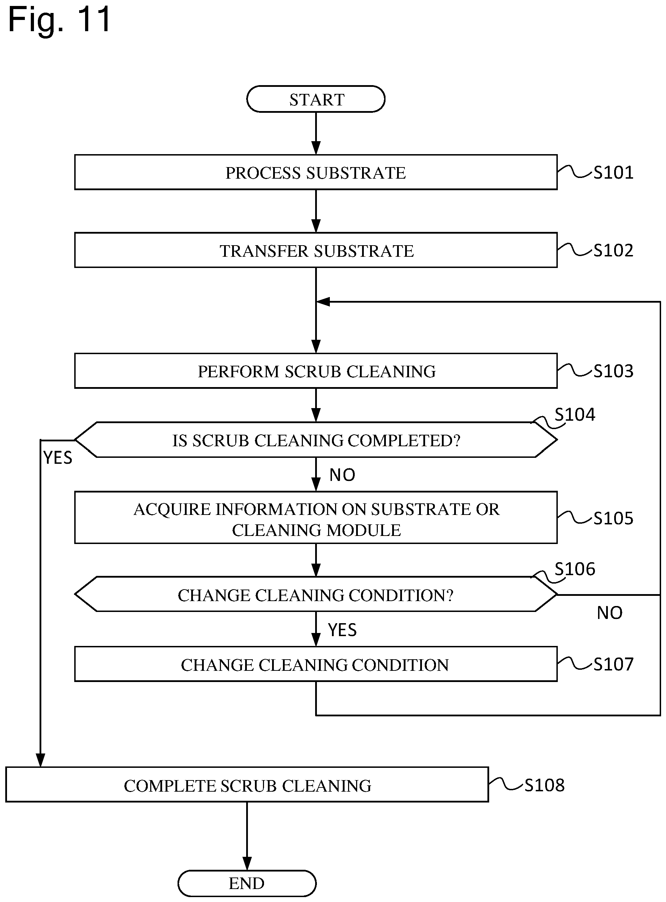

Fig. 11 is a flowchart showing a flow of a substrate processing method including a substrate cleaning method according to the present embodiment. This substrate processing method is performed by the processor 950 of the control device 900.

In step S101, the substrate processing controller 951 performs processing such as polishing on the substrate WF. The processed substrate WF is transferred into the cleaning module 400. After step S101, step S102 is performed. In step S102, the cleaning controller 952 controls the transfer mechanism 2000 of the cleaning module 400, to transfer the substrate WF. The transfer mechanism 2000 transfers the substrate WF along the transfer path 405, and ultrasonic cleaning or the like is performed as appropriate. After step S102, step S103 is performed.

In step S103, the cleaning controller 952 controls the scrub cleaning mechanism 451, to perform the scrub cleaning of the substrate WF. After step S103, step S104 is performed. In step S104, the cleaning controller 952 determines whether to complete the scrub cleaning. If a completion condition is satisfied, step S104 is affirmatively determined and step S108 is performed. The completion condition is a condition to complete the scrub cleaning and include, for example, detection of the separation of the substrate WF from the cleaning member 451 by the second sensor 4216B, or input of a scrub cleaning completion instruction from the user. If the completion condition is not satisfied, step S104 is negatively determined, and step S105 is performed.

In step S105, the cleaning controller 952 acquires information (cleaning information) on the substrate WF or the cleaning module 400. For example, when the drive current of the motor that drives the transfer of the transfer mechanism 2000 is used as the cleaning information, the cleaning controller 952 can monitor the value of the drive current. After step S105, step S106 is performed. In step S106, the cleaning controller 952 determines whether to change the cleaning condition based on the cleaning information acquired in step S105. For example, when the drive current of the motor that drives the transfer of the transfer mechanism 2000 is used as the cleaning information, the cleaning controller 952 can determine to change the cleaning condition when the drive current is equal to or more than the threshold value and can determine not to change the cleaning condition when the drive current is less than the threshold value. When the cleaning condition is changed, step S106 is affirmatively determined, and step S107 is performed. When the cleaning condition is not changed, step S106 is negatively determined, and the processing returns to step S103.

In step S107, the cleaning controller 952 changes the cleaning condition. The cleaning controller 952 controls each component of the cleaning module 400 and changes the rotation axis angle θ or rotation speed of the cleaning member 451 or the transfer speed of the substrate WF. After step S107, the processing returns to step S103. In step S108, the cleaning controller 952 moves the cleaning member 451 from the position in contact with the substrate WF and completes the scrub cleaning. After step S108, the processing ends.

The substrate cleaning apparatus including the cleaning module 400 of the present embodiment includes the cleaning module 400 including the transfer mechanism 2000 for transferring the substrate WF in the transfer direction (first direction), and bringing, into contact with the substrate WF transferred in the transfer direction, the cleaning member 451 rotating about the rotation axis AX extending in the axial direction (second direction) that is not perpendicular to the transfer direction, to perform cleaning, and the control device 900 that changes the cleaning condition including at least one of the direction of the rotation axis AX, the rotation speed of the cleaning member 451 and the transfer speed of the substrate WF based on the information (cleaning information) about at least one of the substrate WF and the cleaning module 400. Thus, a cleaner substrate WF can be provided by adjusting the cleaning condition and performing the scrub cleaning. Furthermore, the scrub cleaning can be performed by rubbing the substrate WF from the plurality of directions, and a further cleaner substrate WF can be provided.

In the cleaning module 400 according to the present embodiment, the first cleaning member 451-1 and the second cleaning member 451-2 are arranged, so that the first cleaning member 451-1 can be the cleaning member 451 for cleaning one surface of the substrate WF, and the second cleaning member 451-2 can be the cleaning member 451 for cleaning the other surface of the substrate WF. Thus, both surfaces of the substrate WF can be scrubbed, and the first cleaning member 451-1 and the second cleaning member 451-2 press the substrate in opposite directions from both the surfaces of the substrate WF, so that the substrate WF can be inhibited from being strongly loaded, deformed, or otherwise damaged.

Such modifications as follow are also within the scope of the present invention and can be combined with the above-described embodiment or other modifications. In the following modifications, a region or the like exhibiting the same structure and function as in the above-described embodiment is denoted with the same reference signs as in the above-described embodiment, and the description is omitted as appropriate.

(Modification 1)

In the above-described embodiment, the cleaning controller 952 may change the cleaning condition based on the detected position of the substrate WF. Thus, the cleaning condition of the substrate WF can be set flexibly.

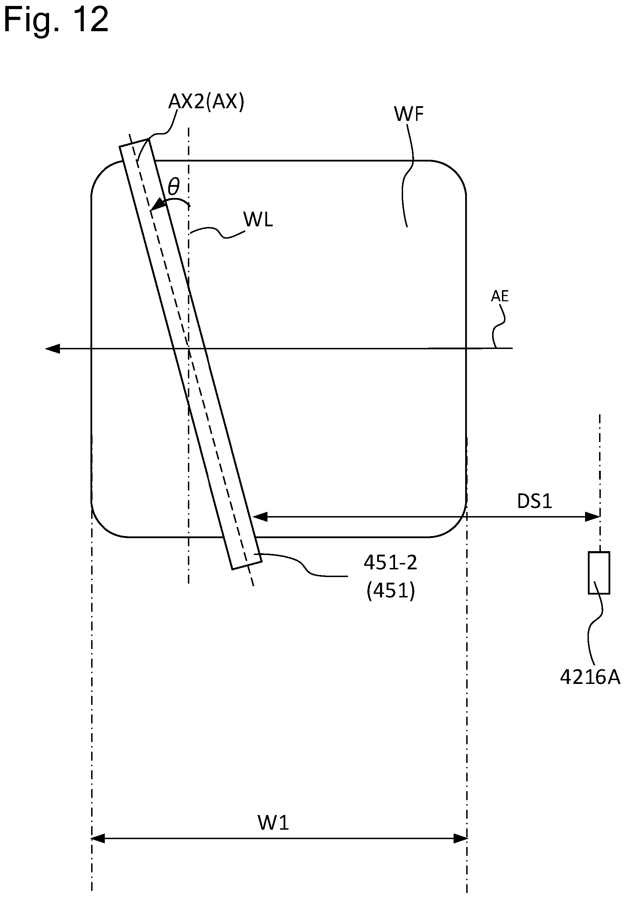

Fig. 12 is a plan view schematically showing an arrangement of the first sensor 4216A in the present modification. The first sensor 4216A is configured to detect the substrate WF at a position only by a first distance DS1 upstream of the cleaning member 451 along the transfer direction (arrow AE). The first sensor 4216A preferably detects that a tip of the substrate WF on a cleaning member 451 side has come to the position from the viewpoint of performing more precise control. The first distance DS1 is not particularly limited if the rotation axis angle θ can be changed before the cleaning member 451 contacts the substrate WF. For example, the first distance DS1 can be a distance based on a width W1 of the substrate WF along the transfer direction and can be a length similar or identical to the width W1.

On receiving a detection signal of the substrate WF from the first sensor 4216A, the cleaning controller 952 changes the rotation axis angle θ to an angle that is neither 0 degrees nor 180 degrees. In other words, the direction of the rotation axis AX is changed to a direction that is along the substrate WF and not perpendicular to the transfer direction. From the viewpoint of efficiently cleaning the entire substrate WF, the rotation axis angle θ is neither 90 degrees nor 270 degrees, and in other words, the direction of the rotation axis AX is preferably changed to a direction that is not parallel to the transfer direction. For example, the rotation axis angle θ may be set preferably to between 1 degree and 45 degrees, between 135 degrees and 179 degrees, between 181 degrees and 225 degrees or between 315 degrees and 359 degrees, more preferably to between 5 degrees and 45 degrees, between 135 degrees and 175 degrees, between 185 degrees and 225 degrees or between 315 degrees and 355 degrees. When the cleaning member extending along the substrate in the width direction of the substrate (in the direction perpendicular to the transfer direction (a direction of line WL)) contacts the substrate, a pressing load changes rapidly over the entire substrate in the width direction, so that the substrate cannot be sufficiently cleaned, or the cleaning member is caught on an edge of the substrate, thereby loading the cleaning module or the substrate and causing damages. In the present modification, the cleaning controller 952 can reduce such adverse effects because the controller changes the direction of the rotation axis AX of the cleaning member 451 immediately before start of the cleaning of the substrate WF. Furthermore, dirty liquid after the cleaning flows also in the width direction due to the rotation of the cleaning member 451 that is not perpendicular to the transfer direction, and the liquid is therefore hard to stay on the substrate WF. From the first distance DS1 and the transfer speed of the substrate WF, a time from the detection by the first sensor 4216A to the start of the scrub cleaning can be calculated. Therefore, the cleaning controller 952 can change the direction of the rotation axis AX along the substrate WF to the direction that is not perpendicular to the transfer direction (the rotation axis angle θ is neither 0 degrees nor 180 degrees) within a predetermined time before time when the cleaning member 451 starts contacting the substrate WF. A degree to which the rotation axis angle θ is to be changed may be determined based on a relative speed of a moving speed of the surface of the cleaning member 451 to the transfer speed of the substrate WF, the above-described rubbing length or rubbing direction, or the like. Alternatively, the direction of the rotation axis AX may be changed continuously or in stages. Furthermore, the rotation speed of the cleaning member 451 or the transfer speed of the substrate WF may be changed.

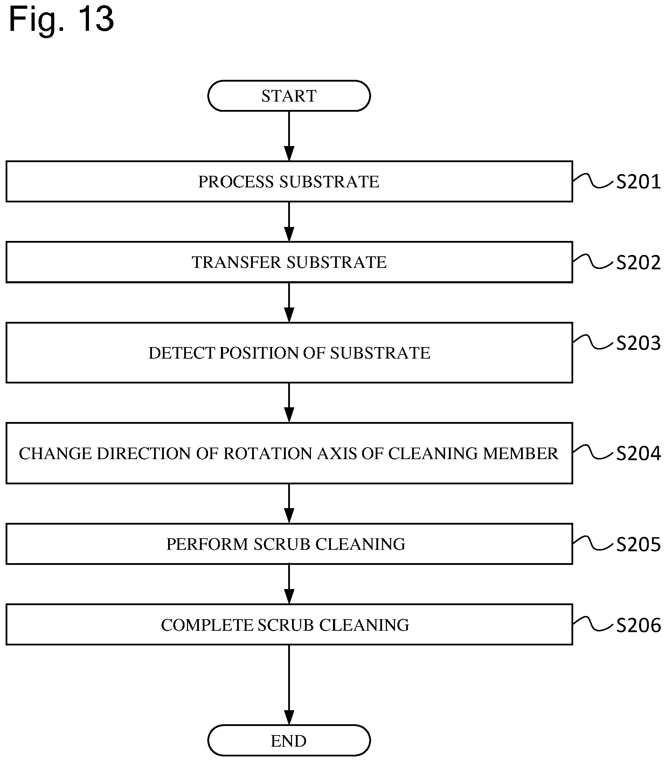

Fig. 13 is a flowchart showing a flow of a substrate processing method including a substrate cleaning method according to the present modification. This substrate processing method is performed by the processor 950 of the control device 900. Steps S201 and S202 are the same as steps S101 and S102 in the flowchart of Fig. 11 described above, respectively, and therefore are not described. After step S202, step S203 is performed. The direction of the rotation axis AX of the cleaning member 451 in step S203 is not particularly limited.

In step S203, the cleaning controller 952 controls the first sensor 4216A to detect the position of the substrate WF. After step S203, step S204 is performed. In step S204, the cleaning controller 952 controls a motor or the like that drives rotation of the cleaning member 451 about an axis perpendicular to the substrate WF, to change the direction of the rotation axis AX of the cleaning member 451. The direction of the rotation axis AX is changed to the direction that is along the substrate WF and not perpendicular to the transfer direction. After step S204, step S205 is performed.

In step S205, the cleaning controller 952 controls the cleaning module 400, to perform the scrub cleaning of the substrate WF. Here, the cleaning controller 952 may change the cleaning condition again from the viewpoint of increasing the efficiency of the scrub cleaning. For example, the cleaning controller 952 can change the direction of the rotation axis AX so that the rotation axis AX approaches the direction perpendicular to the transfer direction (so that the rotation axis angle $\theta$ decreases). Alternatively, the cleaning controller 952 can increase the rotation speed of the cleaning member 451 or increase the transfer speed of the substrate WF. In this way, by changing the cleaning condition between when the cleaning member 451 is brought into contact with the substrate WF and when the scrub cleaning is performed, the scrub cleaning can be efficiently performed while reducing possibility of damaging the substrate WF and the cleaning module 400. In the cleaning controller 952, step S206 is performed after step S205. In step S206, the cleaning controller 952 completes the scrub cleaning, for example, when the above-described completion condition is satisfied. After step S206, the processing ends.

In the substrate cleaning apparatus including the cleaning module 400 of the present modification, the control device 900 changes the direction of the rotation axis AX to the direction that is along the substrate WF and not perpendicular to the transfer direction (second direction) within the predetermined time before the time when the cleaning member 451 starts contacting the substrate WF. Thus, the rotation axis AX can be changed to be non-perpendicular to the transfer direction just before the tip of the substrate WF on the cleaning member 451 side contacts the cleaning member 451. In this case, the substrate WF can be prevented from being insufficiently cleaned due to rapid change in pressing load over the entire substrate in the width direction. Furthermore, the cleaning module 400 or the substrate WF can be prevented from being loaded and damaged due to the cleaning member 451 caught on the edge of the substrate WF.

(Modification 2)

The above-described embodiment may be configured to change the direction of the rotation axis AX of the cleaning member 451 within a predetermined time before time when the cleaning member 451 starts separating from the substrate WF. In this case, the cleaning module 400 includes the same configuration as in Fig. 12, except that the first distance DS1 between the cleaning member 451 and the first sensor 4216A is set to be shorter, for example, than the width W1 of the substrate WF along the transfer direction, to detect a rear end of the substrate WF.

On receiving the detection signal of the substrate WF from the first sensor 4216A, the cleaning controller 952 changes the rotation axis angle $\theta$ to the angle that is neither 0 degrees nor 180 degrees. In other words, the direction of the rotation axis AX is changed to the direction that is along the substrate WF and not perpendicular to the transfer direction. When the cleaning member extending along the substrate in the width direction of the substrate (in the direction perpendicular to the transfer direction (direction of line WL)) separates from the substrate, the pressing load changes rapidly over the entire substrate in the width direction, or the cleaning member is caught on the edge of the substrate, thereby loading the cleaning module or the substrate. In this modification, the cleaning controller 952 changes the direction of the rotation axis AX of the cleaning member 451 to the direction that is along the substrate WF and not perpendicular to the transfer direction just before the cleaning member 451 separates from the substrate WF and can therefore reduce such adverse effects. The degree to which the rotation axis angle $\theta$ is to be changed may be determined based on the relative speed of the moving speed of the surface of the cleaning member 451 to the transfer speed of the substrate WF, the above-described rubbing length or rubbing direction, or the like. Alternatively, the direction of the rotation axis AX may be changed continuously or in stages. Furthermore, the rotation speed of the cleaning member 451 or the transfer speed of the substrate WF may be changed.

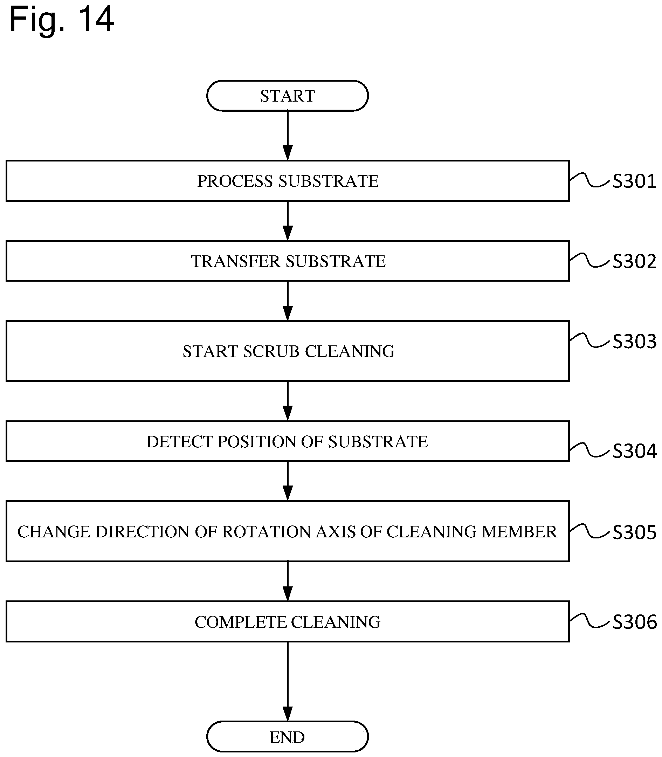

Fig. 14 is a flowchart showing a flow of a substrate processing method including a substrate cleaning method according to the present modification. This substrate processing method is performed by the processor 950 of the control device 900. Steps S301 and S302 are the same as steps S101 and S102, respectively, in the flowchart of Fig. 11 described above and therefore are not described. After step S302, step S303 is performed. The direction of the rotation axis AX of the cleaning member 451 in step S303 is not particularly limited.

In step S303, the cleaning controller 952 controls the cleaning module 400 and performs the scrub cleaning of the substrate WF. After step S303, step S304 is performed. In step S304, the cleaning controller 952 controls the first sensor 4216A, to detect the position of the substrate WF. For example, the cleaning controller 952 is configured to detect that it is the predetermined time before the substrate WF separates, when the first sensor 4216A detects the rear end of the substrate WF. After step S304, step S305 is performed.

In step S305, the cleaning controller 952 controls a motor or the like that that drives rotation of the cleaning member 451 about an axis perpendicular to the substrate WF, to change the direction of the rotation axis AX of the cleaning member 451. The direction of the rotation axis AX is changed to the direction that is along the substrate WF and not perpendicular to the transfer direction. After step S305, step S306 is performed. In step S306, the cleaning controller 952 controls the lifting mechanism 453, separates the cleaning member 451 from the substrate WF, and completes the scrub cleaning. After step S306, the processing ends.

In the substrate cleaning apparatus including the cleaning module 400 of the present modification, the control device 900 changes the direction of the rotation axis AX to the direction that is along the substrate WF and not perpendicular to the transfer direction (second direction) within a predetermined time before the time when the cleaning member 451 starts separating from the substrate WF. Thus, the direction of the rotation axis AX can be changed to be non-perpendicular to the transfer direction just before an end of the substrate WF opposite to the cleaning member 451 separates from the cleaning member 451. In this case, the cleaning module 400 or the substrate WF can be inhibited from being loaded and damaged due to rapid change in pressing load over the entire substrate WF in the width direction and the cleaning member 451 caught on the edge of the substrate WF, when the cleaning member 451 separates.

(Modification 3)

In the above-described embodiment, the substrate WF may be reciprocated along the transfer path and scrub cleaning may be performed on the substrate WF moving in a plurality of different orientations. When an orientation of transfer varies, the rubbing direction or the like differs as represented by the above-described equation (8), so that a cleaner substrate WF can be provided by performing the scrub cleaning in a plurality of rubbing directions.

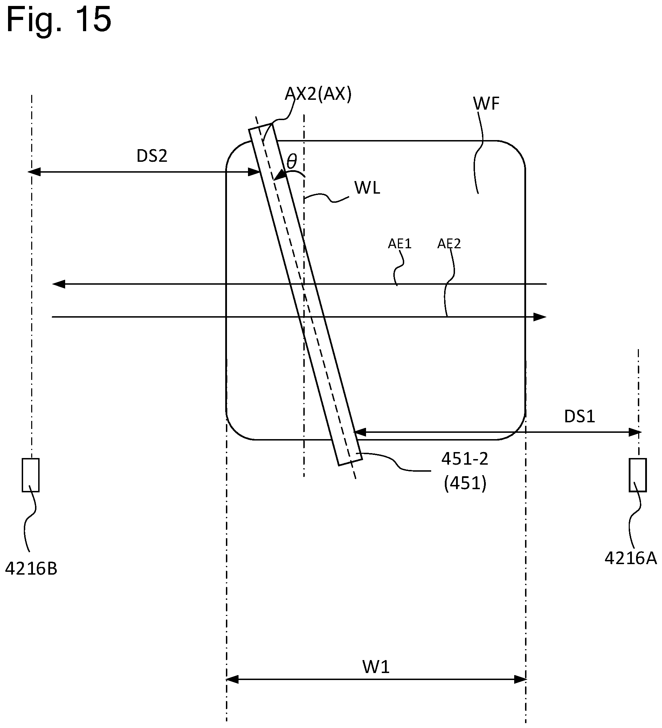

Fig. 15 is a plan view schematically showing an arrangement of the first sensor 4216A and the second sensor 4216B in the present modification. The first sensor 4216A is configured to detect the substrate WF at a position separated by the first distance DS1 from the cleaning member 451 on one side (right side in the drawing) along the transfer direction. The second sensor 4216B is configured to detect the substrate WF at a position separated by a second distance DS2 from the cleaning member 451 on the other side (left side in the drawing) along the transfer direction. The first distance DS1 and the second distance DS2 in the present modification are not particularly limited if the substrate WF can be reciprocated along the transfer direction to perform scrub cleaning with a desired efficiency. The first distance DS1 and the second distance DS2 can be, for example, in a range from the same length as the width W1 along the transfer direction of the substrate WF to about ten times the width W1.

On receiving a first detection signal of the substrate WF identified by, for example, an ID or the like from the first sensor 4216A, the cleaning controller 952 controls the cleaning module 400 to perform scrub cleaning of the substrate WF that moves in a first orientation (arrow AE1) along the transfer direction. Thereafter, on receiving a detection signal of the substrate WF from the second sensor 4216B, the cleaning controller 952 controls the transfer mechanism 2000 to move the substrate WF in a second orientation (arrow AE2) reverse to the first orientation. The cleaning controller 952 controls the cleaning module 400 to perform scrub cleaning of the substrate WF moving in the second orientation (arrow AE2) along the transfer direction. At this time, it is also preferable to orient the rotation of the cleaning member 451 about the rotation axis AX in reverse so that cleaning efficiency is prevented from being reduced. On receiving the detection signal of the substrate WF again from the first sensor 4216A, the cleaning controller 952 controls the transfer mechanism 2000 to move the substrate WF in the reverse orientation (the first orientation (arrow AE1) along the transfer direction). Thereafter, the cleaning controller 952 performs scrub cleaning of the substrate WF moving in the first orientation. Thus, the cleaning controller 952 can perform the scrub cleaning a predetermined number of times based on a numerical value stored in the storage 930 or the like by repeatedly orienting the transfer of the substrate WF in reverse. In the scrub cleaning, the cleaning conditions such as the direction of the rotation axis AX, the rotation speed of the cleaning member 451, and the transfer speed of the substrate WF may be the same or different.

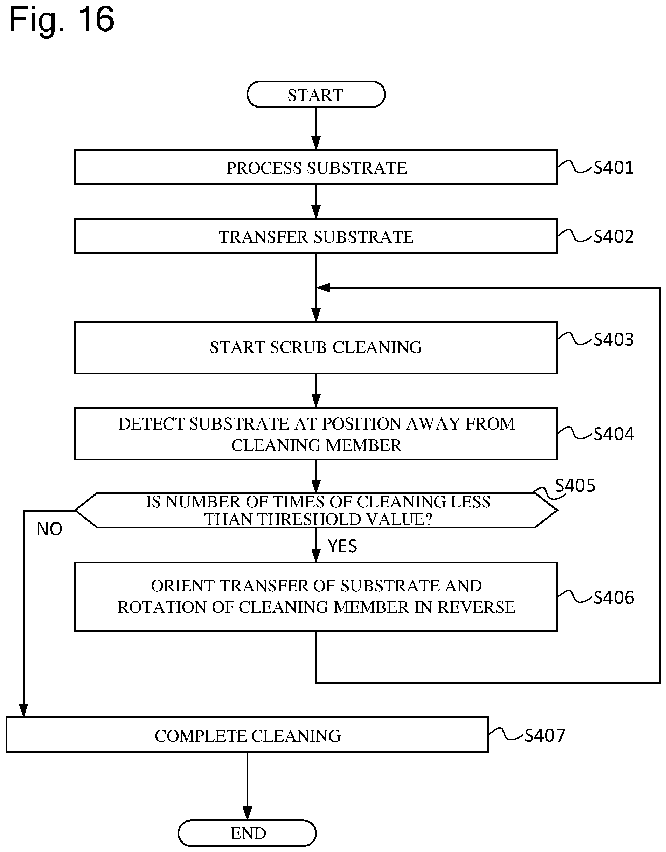

Fig. 16 is a flowchart showing a flow of a substrate processing method including a substrate cleaning method according to the present modification. This substrate processing method is performed by the processor 950 of the control device 900. Steps S401 and S402 are the same as steps S101 and S102, respectively, in the flowchart of Fig. 11 described above and therefore are not described. After step S402, step S403 is performed. The direction of the rotation axis AX of the cleaning member 451 in step S403 is not particularly limited.

In step S403, the cleaning controller 952 controls the cleaning module 400, to start scrub cleaning of the substrate WF. After step S403, step S404 is performed. In step S404, the cleaning controller 952 controls the first sensor 4216A or the second sensor 4216B, to detect the substrate WF at a position away from the cleaning member 451. After step S404, step S405 is performed.

In step S405, the cleaning controller 952 determines whether the number of times of cleaning is less than or equal to a threshold value. For example, the cleaning controller 952 resets a predetermined variable to 0 before cleaning the substrate WF with a new ID and can increment the variable by one each time the scrub cleaning is started in step S403. In this case, in step S405, the cleaning controller 952 may determine whether the variable is less than the threshold value stored in the storage 930 or the like. If the number of the times of cleaning is less than the threshold value, step S405 is affirmatively determined and step S406 is performed. If the number of the times of cleaning is equal to or more than the threshold value, step S405 is negatively determined and step S407 is performed.

In step S406, the cleaning controller 952 controls a motor or the like that drives the rotation of the transfer mechanism 2000 and the cleaning member 451, to orient, in reverse, the transfer of the substrate WF and the rotation of the cleaning member 451 about the rotation axis AX. After step S406, the processing returns to step S403. In step S407, the cleaning controller 952 completes the cleaning and controls the transfer mechanism 2000 to transfer the substrate WF out of the scrub cleaning mechanism 450. After step S407, the processing ends.

In the substrate cleaning apparatus including the cleaning module 400 according to the present modification, the control device 900 can change the transfer of the substrate WF and the rotation of the cleaning member 451 to the reverse orientation when the cleaning member 451 completely separates from the substrate WF. Here, "complete separation" indicates that the rear end of the substrate WF is entirely separated from the cleaning member 451. For example, in the case of a rectangular substrate, it is indicated that a side constituting the rear end of the substrate WF is entirely separated from the cleaning member 451. Thus, the scrub cleaning can be performed in a plurality of rubbing directions using the same cleaning member 451, and the scrub cleaning of the substrate WF can be efficiently performed.

In the substrate cleaning apparatus including the cleaning module according to the present modification, the control device 900 changes the transfer of the substrate WF and the rotation of the cleaning member 451 to the reverse orientation the predetermined number of times. Thus, the number of times of cleaning can be appropriately set depending on a type or the like of substrate WF, and scrub cleaning can be efficiently performed.

(Modification 4)

In the above-described embodiment, a plurality of protrusions may be formed on the surface of the cleaning member in contact with the substrate.

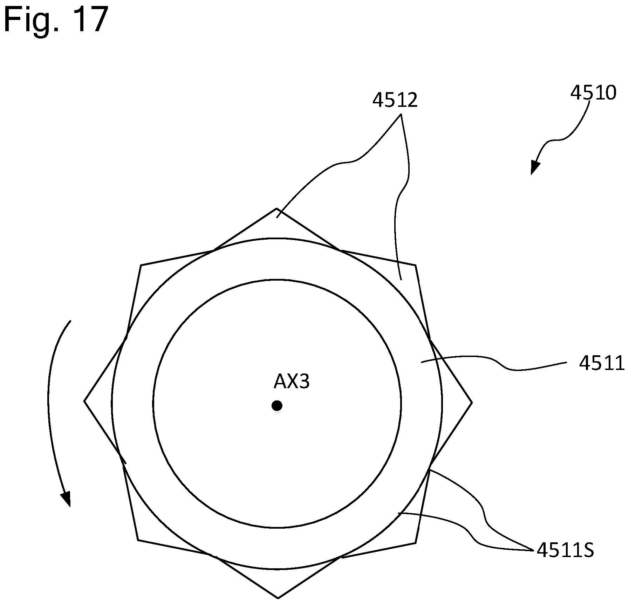

Fig. 17 is a top view schematically showing a cleaning member 4510 according to the present modification. In the cleaning member 4510, a plurality of protrusions 4512 is formed on a side surface 4511S corresponding to a columnar surface of a cylindrical base 4511 to improve efficiency of cleaning. Fig. 17 corresponds to a view of the cleaning member 4510 viewed from a direction in which a rotation axis AX3 of the cylindrical base 4511 extends. The plurality of protrusions 4512 has a shape that is not particularly limited if scrub cleaning is possible. However, if the protrusions are caught on the substrate WF, the substrate WF or the cleaning module 400 may be damaged, and hence each protrusion preferably has a reduced width along a radial direction from the rotation axis AX3 so that the protrusion is not easily caught on the substrate WF.

As described above, when the plurality of protrusions 4512 is formed on the cleaning member 4510, a problem may arise that the protrusions are easily caught on the substrate WF. However, in the cleaning module according to the above-described embodiment, the rotation axis of the cleaning member is set to a direction that is not perpendicular to the transfer direction of the substrate, and when the cleaning member contacts the substrate and when the cleaning member separates from the substrate, any rapid load change does not occur on the substrate, and the cleaning member is not easily caught on the substrate. Therefore, if the cleaning member 4510 including the plurality of protrusions 4512 formed as in the present modification is applied to the above-described embodiment, the cleaning member is particularly preferable because the above problems are unlikely to occur, and the efficiency of the cleaning can be improved.

(Modification 5)

In the above-described embodiment, scrub cleaning may be performed by bringing a plurality of cleaning members having different rotation axis angles into contact with one surface of the substrate WF. Thus, scrub cleaning can be performed efficiently in a plurality of rubbing directions.

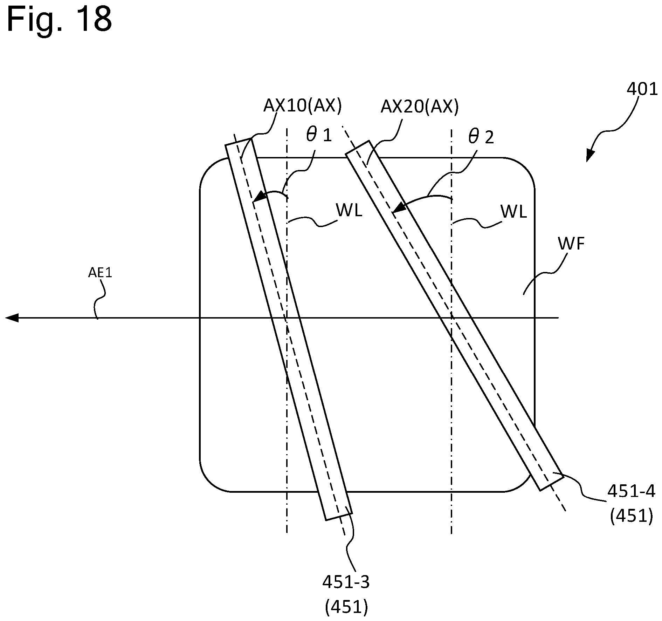

Fig. 18 is a conceptual diagram for describing an arrangement of the cleaning member 451 according to the present modification. A cleaning module 401 according to the present modification includes a plurality of cleaning members 451-3 and 451-4 contacting one surface of the substrate WF to perform scrub cleaning. A rotation axis angle $\theta 1$ of the cleaning member 451-3 and a rotation axis angle $\theta 2$ of the cleaning member 451-4 are different. When the cleaning member 451 contacts the substrate WF and when the cleaning member separates from the substrate WF, to reduce adverse effects due to rapid loading over the substrate WF in the width direction (direction of line WL), it is preferable that the rotation axis angle $\theta 1$ is not 0 or 180 degrees and that the rotation axis angle $\theta 2$ is not 0 or 180 degrees. From the viewpoint of efficiently performing scrub cleaning, it is preferable that a direction of a rotation axis AX10 of the cleaning member 451-3 and a direction of a rotation axis AX20 of the cleaning member 451-4 are different from the transfer direction (arrow AE1) ($\theta 1$ is not 90 or 270 degrees, $\theta 2$ is not 90 or 270 degrees).

In addition, scrub cleaning may be performed by bringing a plurality of cleaning members 451 having different rotation axis angles θ into contact with both surfaces of the substrate WF. The cleaning controller 952 may or may not change the cleaning conditions of each cleaning member 451.

The cleaning module 401 according to the present modification brings, into contact with at least one surface of the substrate WF transferred in the transfer direction, a plurality of cleaning members 451 rotating about respective rotation axes extending in a plurality of different axial directions, to perform cleaning. Thus, by performing scrub cleaning in a plurality of rubbing directions, a further clean substrate WF can be provided.

The embodiment described above can also be described as forms below.

[Form 1] According to Form 1, a substrate cleaning apparatus is provided, comprising a cleaning module including a transfer mechanism for transferring a substrate in a first direction, and bringing, into contact with the substrate transferred in the first direction, a cleaning member rotating about a rotation axis extending in a second direction that is not perpendicular to the first direction, to perform cleaning, and a control device that changes a cleaning condition including at least one of a direction of the rotation axis, a rotation speed of the cleaning member and a transfer speed of the substrate based on information about at least one of the substrate and the cleaning module. According to Form 1, a cleaner substrate can be provided by adjusting the cleaning condition.

[Form 2] According to Form 2, in Form 1, the control device changes the cleaning condition based on whether a component of the substrate cleaning apparatus normally operates during cleaning by the cleaning module. According to Form 2, the substrate or the cleaning module can be inhibited from being damaged due to an abnormal operation of the component of the substrate cleaning apparatus.

[Form 3] According to Form 3, in Form 1 or 2, the control device changes the cleaning condition based on at least one of a drive current and a drive torque of a motor that drives the transfer mechanism or the cleaning member. According to Form 3, the substrate or the cleaning module can be inhibited from being damaged due to an abnormal operation of the motor.

[Form 4] According to Form 4, in Forms 1 to 3, the cleaning module brings, into contact with at least one surface of the substrate transferred in the first direction, a plurality of cleaning members rotating about respective rotation axes extending in a plurality of different second directions, to perform cleaning. According to Form 4, a further cleaner substrate can be provided by performing scrub cleaning for a plurality of rubbing directions.

[Form 5] According to Form 5, in Forms 1 to 4, the transfer mechanism or the cleaning module comprises a detector that detects a position of the substrate, and the control device changes the cleaning condition based on a detected position of the substrate. According to Form 5, the cleaning condition can be set flexibly, and a further cleaner substrate can be provided.

[Form 6] According to Form 6, in Forms 1 to 5, the control device changes the direction of the rotation axis to the second direction within a predetermined time before time when the cleaning member starts contacting the substrate. According to Form 6, the substrate can be prevented from being insufficiently cleaned due to rapid change in pressing load over the entire substrate in the width direction when the cleaning member contacts the substrate. Furthermore, the cleaning module or the substrate can be inhibited from being loaded due to the cleaning member caught on the edge of the substrate.

[Form 7] According to Form 7, in Forms 1 to 6, the control device changes the direction of the rotation axis to the second direction within a predetermined time before time when the cleaning member starts separating from the substrate. According to Form 7, the cleaning module or the substrate can be inhibited from being loaded due to the rapid change in pressing load over the entire substrate in the width direction or due to the cleaning member caught on the edge of the substrate, when the cleaning member separates from the substrate.

[Form 8] According to Form 8, in Forms 1 to 7, the control device changes orientations of transfer of the substrate and of rotation of the cleaning member to reverse orientations, when the cleaning member completely separates from the substrate. According to Form 8, scrub cleaning can be performed in a plurality of rubbing directions using the same cleaning member, and the substrate can be efficiently scrubbed.

[Form 9] According to Form 9, in Form 8, the control device performs change to the reverse orientations a predetermined number of times. According to the Form 9, the number of times of cleaning can be appropriately set according to the type of substrate or the like, and efficient scrub cleaning can be performed.

[Form 10] According to Form 10, in Forms 1 to 9, the cleaning member includes a sponge. According to the Form 10, the sponge has excellent flexibility, elasticity, water absorption, and the like, and scrub cleaning can be accordingly performed further efficiently.

[Form 11] According to Form 11, in Forms 1 to 10, the cleaning member includes a plurality of protrusions formed on a surface that contacts the substrate. According to Form 11, efficiency of cleaning can be increased, and in combination with Forms 1 to 10, the substrate or the cleaning module can be inhibited from being damaged due to the plurality of protrusions caught on the substrate.

[Form 12] According to Form 12, in Forms 1 to 11, the cleaning member is cylindrical. According to Form 12, the substrate can be efficiently scrubbed by rotating the cylindrical cleaning member about a cylindrical shaft.

[Form 13] According to Form 13, in Forms 1 to 12, in the cleaning module, a first cleaning member and a second cleaning member are arranged, the first cleaning member is the cleaning member that cleans one surface of the substrate, and the second cleaning member is the cleaning member that cleans the other surface of the substrate. According to Form 13, both the surfaces of the substrate can be efficiently cleaned, and a substrate with both the surfaces being clean can be provided.

[Form 14] According to Form 14, in Forms 1 to 13, the substrate is a rectangular substrate. According to Form 14, the rectangular substrate transferred in the same orientation as the substrate can be scrubbed in a plurality of rubbing directions or the like, and a cleaner substrate can be provided.

[Form 15] According to Form 15, in Forms 1 to 14, the first direction and the second direction are directions along the surface of the substrate. According to Form 15, a clean substrate can be provided more reliably by adjusting the cleaning condition.

[Form 16] According to Form 16, a substrate processing apparatus is provided, and the substrate processing apparatus comprises the substrate cleaning apparatus of Forms 1 to 15. According to Form 16, a cleaner processed substrate can be provided by adjusting the cleaning condition.

[Form 17] According to Form 17, Form 16 comprises a substrate polishing apparatus and a drying module. According to Form 17, a clean, polished, and dried substrate can be provided.

[Form 18] According to Form 18, a substrate cleaning method is provided, and the substrate cleaning method comprises transferring a substrate in a first direction, bringing, into contact with the substrate transferred in the first direction, a cleaning member rotating about a rotation axis extending in a second direction that is not perpendicular to the first direction, to perform cleaning, and changing a cleaning condition including at least one of a direction of the rotation axis, a rotation speed of the cleaning member and a transfer speed of the substrate based on information about at least one of the substrate and the cleaning module. According to Form 18, a cleaner substrate can be provided by adjusting the cleaning condition.

[Form 19] According to Form 19, a program is provided, and the program causes a processor of a substrate cleaning apparatus comprising a cleaning module to perform change processing of changing a cleaning condition including at least one of a direction of a rotation axis, a rotation speed of a cleaning member and a transfer speed of a substrate based on information about at least one of the substrate and the cleaning module, the cleaning module including a transfer mechanism for transferring the substrate in a first direction, and bringing, into contact with the substrate transferred in the first direction, the cleaning member rotating about the rotation axis extending in a second direction that is not perpendicular to the first direction, to perform cleaning. According to Form 19, a cleaner substrate can be provided by adjusting the cleaning condition.

Although the embodiments of the present invention have been described above, the described embodiments are for the purpose of facilitating the understanding of the present invention and are not intended to limit the present invention. The present invention may be modified and improved without departing from the spirit thereof, and the invention includes equivalents thereof. In addition, the elements described in the claims and the specification can be arbitrarily combined or omitted within a range in which the above-mentioned problems are at least partially solved, or within a range in which at least a part of the advantages is achieved.

This application claims priority under the Paris Convention to Japanese Patent Application No. 2022-64479 filed on April 8, 2022. The entire disclosure of Japanese Patent Application No. 2022-64479 filed on April 8, 2022 including the specification, claims, drawings and summary is incorporated herein by reference in its entirety. The entire disclosures of Japanese Patent No. 4287551 (PTL 1), Japanese Patent Laid Open No. 2009-128910 (PTL 2), and Japanese Patent Publication No. HEI 06-091986 (PTL 3) including the specification, claims, drawings and summary are incorporated herein by reference in their entirety.

REFERENCE SIGNS LIST

11 processing surface
100 load module
200, 200A, 200B transfer module
202 transfer roller
204 roller shaft
220 stopper
230 pusher
300, 300A, 300B polishing module

302 top ring
352 polishing pad
400, 401 cleaning module
405 transfer path
450, 450A, 450B scrub cleaning mechanism
453, 453-1, 453-2 lifting mechanism
451, 451-1, 451-2, 451-3, 451-4, 4510 cleaning member
500 drying module
600 unload module
900 control device
950 processor
951 substrate processing controller
952 cleaning controller
953 display controller
959 memory
1000 substrate processing apparatus
2000 transfer mechanism
4216A first sensor
4216B second sensor
4512 plurality of protrusions
AX, AX1, AX2, AX3, AX10, AX20 rotation axis of cleaning member
WF substrate
θ, θ1, θ2 rotation axis angle

**Claims**

1. A substrate cleaning apparatus comprising:

   a cleaning module including a transfer mechanism for transferring a substrate in a first direction, and bringing, into contact with the substrate transferred in the first direction, a cleaning member rotating about a rotation axis extending in a second direction that is not perpendicular to the first direction, to perform cleaning, and
   a control device that changes a cleaning condition including at least one of a direction of the rotation axis, a rotation speed of the cleaning member and a transfer speed of the substrate based on information about at least one of the substrate and the cleaning module.

2. The substrate cleaning apparatus according to claim 1, wherein the control device changes the cleaning condition based on whether a component of the substrate cleaning apparatus normally operates during cleaning by the cleaning module.

3. The substrate cleaning apparatus according to claim 1 or 2, wherein the control device changes the cleaning condition based on at least one of a drive current and a drive torque of a motor that drives the transfer mechanism or the cleaning member.

4. The substrate cleaning apparatus according to any one of claims 1 to 3, wherein the cleaning module brings, into contact with at least one surface of the substrate transferred in the first direction, a plurality of cleaning members rotating about respective rotation axes extending in a plurality of different second directions, to perform cleaning.

5. The substrate cleaning apparatus according to any one of claims 1 to 4, wherein the transfer mechanism or the cleaning module comprises a detector that detects a position of the substrate, and
   the control device changes the cleaning condition based on a detected position of the substrate.

6. The substrate cleaning apparatus according to any one of claims 1 to 5, wherein the control device changes the direction of the rotation axis to the second direction within a predetermined time before time when the cleaning member starts contacting the substrate.

7. The substrate cleaning apparatus according to any one of claims 1 to 6, wherein the control device changes the direction of the rotation axis to the second direction within a predetermined time before time when the cleaning member starts separating from the substrate.

8. The substrate cleaning apparatus according to any one of claims 1 to 7, wherein the control device changes orientations of transfer of the substrate and of rotation of the cleaning member to reverse orientations, when the cleaning member completely separates from the substrate.

9. The substrate cleaning apparatus according to claim 8, wherein the control device performs change to the reverse orientations a predetermined number of times.

10. The substrate cleaning apparatus according to any one of claims 1 to 9, wherein the cleaning member includes a sponge.

11. The substrate cleaning apparatus according to any one of claims 1 to 10, wherein the cleaning member includes a plurality of protrusions formed on a surface that contacts the substrate.

12. The substrate cleaning apparatus according to any one of claims 1 to 11, wherein the cleaning member is cylindrical.

13. The substrate cleaning apparatus according to any one of claims 1 to 12, wherein in the cleaning module, a first cleaning member and a second cleaning member are arranged,

the first cleaning member is the cleaning member that cleans one surface of the substrate, and
the second cleaning member is the cleaning member that cleans the other surface of the substrate.

14. The substrate cleaning apparatus according to any one of claims 1 to 13, wherein the substrate is a rectangular substrate.

15. The substrate cleaning apparatus according to any one of claims 1 to 14, wherein the first direction and the second direction are directions along the surface of the substrate.

16. A substrate processing apparatus comprising the substrate cleaning apparatus according to any one of claims 1 to 15.

17. The substrate processing apparatus according to claim 16, further comprising a substrate polishing apparatus and a drying module.

18. A substrate cleaning method comprising:

transferring a substrate in a first direction,
bringing, into contact with the substrate transferred in the first direction, a cleaning member rotating about a rotation axis extending in a second direction that is not perpendicular to the first direction, to perform cleaning, and changing a cleaning condition including at least one of a direction of the rotation axis, a rotation speed of the cleaning member and a transfer speed of the substrate based on information about at least one of the substrate and the cleaning module.

19. A program for causing a processor of a substrate cleaning apparatus comprising a cleaning module to perform change processing of changing a cleaning condition including at least one of a direction of a rotation axis, a rotation speed of a cleaning member and a transfer speed of a substrate based on information about at least one of the substrate and the cleaning module, the cleaning module including a transfer mechanism for transferring the substrate in a first direction, and bringing, into contact with the substrate transferred in the first direction, the cleaning member rotating about the rotation axis extending in a second direction that is not perpendicular to the first direction, to perform cleaning.

Fig. 1

EP 4 506 981 A1

## Fig. 2

# Fig. 3

Fig. 4

EP 4 506 981 A1

# Fig. 5

Fig. 6

Fig. 7

EP 4 506 981 A1

Fig. 8

AX2(AX)

WF

WL

θ

AE

451-2
(451)

AR30

451-2
(451)  AX2(AX)   WF

AX1(AX)

451-1
(451)

R1

# Fig. 9

# Fig. 10

900

CONTROL DEVICE

| COMMUNICATOR | 910 |
| INPUT SECTION | 920 |
| STORAGE | 930 |
| DISPLAY | 940 |

950

PROCESSOR (PROCESSING DEVICE)

| SUBSTRATE PROCESSING CONTROLLER | 951 |
| CLEANING CONTROLLER | 952 |
| DISPLAY CONTROLLER | 953 |
| MEMORY | 959 |

# Fig. 11

```
                        ┌──────────┐
                        │  START   │
                        └────┬─────┘
                             ▼
        ┌─────────────────────────────────────┐
        │        PROCESS SUBSTRATE            │──── S101
        └─────────────────┬───────────────────┘
                          ▼
        ┌─────────────────────────────────────┐
        │        TRANSFER SUBSTRATE           │──── S102
        └─────────────────┬───────────────────┘
                          ▼
        ┌─────────────────────────────────────┐
        │      PERFORM SCRUB CLEANING         │──── S103
        └─────────────────┬───────────────────┘
                          ▼
                                                   S104
        < IS SCRUB CLEANING COMPLETED? >
   YES │              │ NO
        │                 ▼
        │   ┌─────────────────────────────────────┐
        │   │  ACQUIRE INFORMATION ON SUBSTRATE OR │──── S105
        │   │         CLEANING MODULE              │
        │   └─────────────────┬───────────────────┘
        │                     ▼                      S106
        │     < CHANGE CLEANING CONDITION? >
        │              │ YES          NO
        │              ▼
        │   ┌─────────────────────────────────────┐
        │   │     CHANGE CLEANING CONDITION        │──── S107
        │   └─────────────────────────────────────┘
        ▼
        ┌─────────────────────────────────────┐
        │       COMPLETE SCRUB CLEANING       │──── S108
        └─────────────────┬───────────────────┘
                          ▼
                     ┌──────────┐
                     │   END    │
                     └──────────┘
```

Fig. 12

# Fig. 13

```
                    ┌──────────────┐
                    │    START     │
                    └──────┬───────┘
                           │
                           ▼
  ┌────────────────────────────────────────────────────┐
  │              PROCESS SUBSTRATE                       │───S201
  └────────────────────────┬───────────────────────────┘
                           │
                           ▼
  ┌────────────────────────────────────────────────────┐
  │              TRANSFER SUBSTRATE                      │───S202
  └────────────────────────┬───────────────────────────┘
                           │
                           ▼
  ┌────────────────────────────────────────────────────┐
  │          DETECT POSITION OF SUBSTRATE               │───S203
  └────────────────────────┬───────────────────────────┘
                           │
                           ▼
  ┌────────────────────────────────────────────────────┐
  │  CHANGE DIRECTION OF ROTATION AXIS OF CLEANING MEMBER│───S204
  └────────────────────────┬───────────────────────────┘
                           │
                           ▼
  ┌────────────────────────────────────────────────────┐
  │            PERFORM SCRUB CLEANING                   │───S205
  └────────────────────────┬───────────────────────────┘
                           │
                           ▼
  ┌────────────────────────────────────────────────────┐
  │           COMPLETE SCRUB CLEANING                   │───S206
  └────────────────────────┬───────────────────────────┘
                           │
                           ▼
                    ┌──────────────┐
                    │     END      │
                    └──────────────┘
```

# Fig. 14

```
          ┌─────────────┐
          │    START    │
          └─────────────┘
                 │
                 ▼
┌─────────────────────────────────────────┐
│            PROCESS SUBSTRATE             │ ～S301
└─────────────────────────────────────────┘
                 │
                 ▼
┌─────────────────────────────────────────┐
│            TRANSFER SUBSTRATE            │ ～S302
└─────────────────────────────────────────┘
                 │
                 ▼
┌─────────────────────────────────────────┐
│           START SCRUB CLEANING           │ ～S303
└─────────────────────────────────────────┘
                 │
                 ▼
┌─────────────────────────────────────────┐
│        DETECT POSITION OF SUBSTRATE      │ ～S304
└─────────────────────────────────────────┘
                 │
                 ▼
┌──────────────────────────────────────────────────────────┐
│ CHANGE DIRECTION OF ROTATION AXIS OF CLEANING MEMBER      │ ～S305
└──────────────────────────────────────────────────────────┘
                 │
                 ▼
┌─────────────────────────────────────────┐
│            COMPLETE CLEANING             │ ～S306
└─────────────────────────────────────────┘
                 │
                 ▼
          ┌─────────────┐
          │     END     │
          └─────────────┘
```

# Fig. 15

# Fig. 16

START

PROCESS SUBSTRATE — S401

TRANSFER SUBSTRATE — S402

START SCRUB CLEANING — S403

DETECT SUBSTRATE AT POSITION AWAY FROM CLEANING MEMBER — S404

IS NUMBER OF TIMES OF CLEANING LESS THAN THRESHOLD VALUE? — S405

NO

YES

ORIENT TRANSFER OF SUBSTRATE AND ROTATION OF CLEANING MEMBER IN REVERSE — S406

COMPLETE CLEANING — S407

END

# Fig. 17

4512

4510

4511

AX3

4511S

Fig. 18

## INTERNATIONAL SEARCH REPORT

| International application No. |
| --- |
| **PCT/JP2023/014402** |

### A. CLASSIFICATION OF SUBJECT MATTER

*H01L 21/304*(2006.01)i
FI:   H01L21/304 644G; H01L21/304 644E; H01L21/304 648G; H01L21/304 621B; H01L21/304 622Q

According to International Patent Classification (IPC) or to both national classification and IPC

### B. FIELDS SEARCHED

Minimum documentation searched (classification system followed by classification symbols)
H01L21/304

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X | CD-ROM of the specification and drawings annexed to the request of Japanese Utility Model Application No. 107290/1991 (Laid-open No. 55546/1993) (NEC KANSAI LTD.) 23 July 1993 (1993-07-23), paragraphs [0002]-[0003], [0006]-[0011], fig. 1, 3-4 | 1, 6-7, 12-16, 18-19 |
| Y | | 1-19 |
| Y | JP 4287551 B2 (SHIBAURA MECHATRONICS CORP) 01 July 2009 (2009-07-01) paragraphs [0019]-[0052], fig. 1-7 | 1-19 |
| Y | JP 2021-103723 A (EBARA CORP) 15 July 2021 (2021-07-15) paragraphs [0035]-[0083], fig. 1-15 | 1-19 |
| Y | JP 2008-4747 A (DAINIPPON SCREEN MFG CO LTD) 10 January 2008 (2008-01-10) paragraphs [0025]-[0074], fig. 1-13 | 1-19 |
| Y | JP 2016-64357 A (SHIBAURA MECHATRONICS CORP) 28 April 2016 (2016-04-28) paragraphs [0007], [0014]-[0026], fig. 1-2 | 1-19 |
| Y | JP 7-241534 A (DAINIPPON SCREEN MFG CO LTD) 19 September 1995 (1995-09-19) paragraphs [0008]-[0026], fig. 1-7 | 1-19 |

[✓] Further documents are listed in the continuation of Box C.     [✓] See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **13 June 2023** | **20 June 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT

| | International application No. |
|---|---|
| | **PCT/JP2023/014402** |

**C.    DOCUMENTS CONSIDERED TO BE RELEVANT**

| Category* | Citation of document, with indication, where appropriate, of the relevant passages | Relevant to claim No. |
|---|---|---|
| Y | JP 10-314684 A (SPEEDFAM CO LTD) 02 December 1998 (1998-12-02) paragraphs [0013]-[0029], fig. 1-8 | 10-11 |
| A | JP 2005-191216 A (DAINIPPON SCREEN MFG CO LTD) 14 July 2005 (2005-07-14) entire text, all drawings | 1-19 |

Form PCT/ISA/210 (second sheet) (January 2015)

INTERNATIONAL SEARCH REPORT
Information on patent family members

International application No.

**PCT/JP2023/014402**

| Patent document cited in search report | | | Publication date (day/month/year) | Patent family member(s) | Publication date (day/month/year) |
|---|---|---|---|---|---|
| JP | 5-55546 | U1 | 23 July 1993 | (Family: none) | |
| JP | 4287551 | B2 | 01 July 2009 | (Family: none) | |
| JP | 2021-103723 | A | 15 July 2021 | US 2022/0406633 A1<br>paragraphs [0132]-[0182], fig. 1-15<br>WO 2021/132122 A1<br>TW 202143319 A<br>KR 10-2022-0107317 A<br>CN 114846584 A | |
| JP | 2008-4747 | A | 10 January 2008 | KR 10-2007-0121598 A<br>CN 101093789 A<br>TW 200814183 A | |
| JP | 2016-64357 | A | 28 April 2016 | (Family: none) | |
| JP | 7-241534 | A | 19 September 1995 | (Family: none) | |
| JP | 10-314684 | A | 02 December 1998 | US 6012193 A<br>2nd paragraph, line 50 to 5th paragraph, line 48, fig. 1-8 | |
| JP | 2005-191216 | A | 14 July 2005 | (Family: none) | |

Form PCT/ISA/210 (patent family annex) (January 2015)

**REFERENCES CITED IN THE DESCRIPTION**

**Patent documents cited in the description**

- JP 4287551 B
- JP 2009128910 A
- JP HEI06091986 A
- JP 2022064479 A